# EUROPÄISCHE PATENTSCHRIFT

(11) **EP 3 759 746 B1**
(45) Veröffentlichungstag und Bekanntmachung des Hinweises auf die Patenterteilung: **08.09.2021**
(21) Anmeldenummer: 19702392.2
(22) Anmeldetag: 28.01.2019
(51) Int. Cl.: H01L 41/27, H01L 41/45

(54) **VERFAHREN ZUR AUFBRINGUNG WENIGSTENS EINER SILICONSCHICHT MITTELS LASER-TRANSFERDRUCK**
METHOD FOR APPLYING AT LEAST ONE SILICONE LAYER BY LASER TRANSFER PRINTING
PROCÉDÉ POUR APPLIQUER AU MOINS UNE COUCHE DE SILICONE AU MOYEN D'UNE IMPRESSION PAR TRANSFERT LASER

(43) Veröffentlichungstag der Anmeldung: 06.01.2021
(73) Patentinhaber: Wacker Chemie AG, 81737 München (DE)
(72) Erfinder: ELLER, Klaus, 84489 Burghausen (DE); KOELLNBERGER, Andreas, 84375 Kirchdorf (DE); NEUWIRTH, Johannes, 5110 Oberndorf (AT)
(74) Vertreter: Bitterlich, Bianca
(86) Internationale Anmeldenummer: PCT/EP2019/052019
(87) Internationale Veröffentlichungsnummer: WO 2020/156632

(56) Entgegenhaltungen:
- US-A1- 2003 104 309
- US-A1- 2011 151 614

## Beschreibung

Die Erfindung betrifft ein Verfahren zur Aufbringung wenigstens einer Siliconschicht mittels Laser-Transferdruck, wobei dieses Verfahren für die Herstellung von Sensoren, Aktoren und anderen EAP-Schichtsystemen geeignet ist.

Die Siliconschicht kann in diesen Systemen dabei als elektrisch leitende Elektrodenschicht oder als dielektrische Schicht dienen. Das Verfahren kann kontinuierlich ausgestaltet sein und mit verschiedenen anderen Beschichtungstechniken kombiniert werden.

### Stand der Technik

Es sind verschiedene Verfahren zur Herstellung von Siliconschichten bzw. Schichtsystemen auf Siliconbasis im Stand der Technik bekannt.

DE 19644112 A1 beschreibt ein kontinuierliches Herstellungsverfahren von Siliconkautschuk-Giessfolien. Hierbei wird eine zweikomponentige Siliconmasse auf einem Umlaufband in entsprechender Dicke und Breite gegossen. Auf dem Umlaufband erfolgt durch Wärmeeintrag aus Heizungen eine thermisch aktivierte Vulkanisation. Nach Aushärten der Folie wird diese von Umlaufband abgenommen, nochmalig getempert und schließlich aufgerollt.

WO 2014/090506 A1 beschreibt ein Verfahren zur kontinuierlichen Herstellung dünner Siliconfolien mit gleichmäßiger Foliendicke, sowie die nach diesem Verfahren hergestellten Siliconfolien und deren Verwendung. Hierbei wird durch eine Schlitzdüse eine Siliconmasse auf einem Trägerband extrudiert und ausgehärtet. Nach dem Aushärten kann die Folie vom Trägerband abgenommen oder mit dem Trägerband aufgewickelt werden.

WO 2015/113911 A1 beschreibt ein Verfahren zur Herstellung von Mehrschichtverbunden mit wenigstens zwei dünnen Siliconschichten mit gleichmäßiger Schichtdicke.

US 2016/0057835 A1 beschreibt die Herstellung von elektroaktiven Schichtsystemen und Bauteilen. Dabei werden Verfahren und Schritte zur Erzeugung von flächigen Elektroden (leitfähigen Schichten) auf nicht leitfähigen Schichten beschrieben. Weiter wird die Verwendung mit elektrochemischen Füllstoffen oder Schichten erwähnt.

US 2016/156066 A1 beschreibt ein Verfahren zur Modifizierung von dünnen Polymerschichten durch Gasphasenabscheidung (i-CVD) mit unterschiedlichen Dotierstoffen. Dabei wird ein Polymer in einem Vakuumprozess homogen und sehr dünn mit variablen Dotierstoffen auf beliebigen Oberflächen oder Geometrien abgeschieden.

WO 2014/187976 A1 beschreibt ein Verfahren zur Herstellung eines Elastomerbasierten Folienstapelaktors mittels eines kontinuierlichen Laminierprozesses (Trocken-Deposition im Rolle zu Rolle Verfahren). Das Laminat wird durch vorangegangenes Ablösen der Elastomer-Folie von einer Träger- und Kaschierfolie, das Ablegen dieser auf einer weiteren, mit Elektrodenmaterial bedruckten, Elastomer-Folie und mehrfachen Wiederholung dieser Schritte erzeugt.

DE 10 2014 005 851 A1 beschreibt eine Vorrichtung und ein kontinuierliches Stapelverfahren zur Erzeugung von Elastomer-Stapelaktoren. Das Verfahren beschränkt sich auf das lagengenaue Laminieren des zugeführten und bereits beschichteten Elektrode-Elastomer-Folienverbunds. Mittels umlaufenden Trägerbandes oder kontinuierlichen Zuführung kommt es bei mehrfacher Wiederholung des Laminiervorgangs zum Aufbau einer Mehrschicht-Struktur. Die Lagengenauigkeit erfolgt mittels Justiereinheit und optischer und elektrischer Sensorik. Die Kontaktierung der Elektroden erfolgt nach jedem Laminierschritt mittels Durchlochung und Auffüllen mit Kontaktierungsmittel.

WO 2014/074554 A2 beschreibt ein Verfahren zum Herstellen eines mehrschichtigen gestapelten elektroaktiven Wandlers in einem Kreisprozess. Über zwei unabhängige Rollen werden die ultradünnen elektroaktiven Polymerfilme, welche zuvor von einem Trägerband abgelöst wurden, einem kontinuierlichen Laminierschritt zugeführt. Der Gesamtprozess enthält zudem Druckstationen für Elektroden sowie Klebstoffaufbringung vor dem jeweiligen Laminierschritt.

DE 10 2014 003 357 A1 beschreibt ein Verfahren zur Herstellung einer oberflächenmodifizierten Siliconschicht. Dabei werden auf eine unvernetzte Siliconschicht elektrisch leitfähige Partikel (Ruß, CNT, Silbernanopartikel) aufgebracht und anschließend im Verbund ausgehärtet. Die Methode der Partikelaufbringung bezieht sich auf eine mechanische Aufbringung mit teilweiser Eindringung in die Siliconoberfläche.

Die bekannten Verfahren zur Auftragung von Siliconschichten insbesondere solche, die zur Herstellung von Elektrodenschichten und/oder dielektrischer Schichten in Aktoren, Sensoren und anderen elektroaktiven Polymerschichtsystemen geeignet sind, sind in ihrer Variabilität, Auftragegenauigkeit, Durchsatz, sowie in der spätere erreichte Bauteileffektivität und Beständigkeit beschränkt.

Zur Auftragung von Schichten ist im Stand der Technik unter anderem das sogenannte Lasertransferdruck-Verfahren bekannt. Dieses Verfahren beschränkt sich jedoch in seiner Anwendung bisher auf niedrigviskose Tinten und Dispersionen sowie Metalle.

WO 2009/153192 A2 beschreibt beispielsweise ein Verfahren zur Herstellung leitfähiger Schichten auf Halbleiterstrukturen, wobei eine Metallpulverdispersion auf einen Träger aufgebracht und durch einen Laserstrahl vom Träger auf ein Target abgelöst wird.

WO 2010/069900 A1 beschreibt beispielsweise den Laser-Transferdruck von Farbe.

WO 2015/181810 A1 beschreibt ein Lasertransfer-Verfahren zum Drucken von metallischen Körpern. Ein Metallfilm auf einen transparenten Träger wird dabei punktuell erhitzt und in Form von Tropfen positioniert.

Aufgabe der vorliegenden Erfindung war es daher, ein flexibles Verfahren zu entwickeln, dass es ermöglicht, Siliconschichten effektiv aufzubringen, wobei das Verfahren die Herstellung von Silicon-Schichten oder Silicon-Schichtsystemen als Dielektrika und Elektrodenschichten für Sensoren, Aktoren oder sonstigen Elementen auf Basis von elektroaktiven Polymeren (EAP) ermöglichen sollte.

Diese Aufgabe wird überraschenderweise durch die vorliegende Erfindung gelöst. Der Auftrag von Siliconschichten mittels Laser-Transferdruck ermöglicht die effektive Herstellung einer EAP-Schicht oder eines EAP-Schichtsystems in einer Anlagesowie den Druck elektronischer Elemente wie Leiterbahnen, Heizungen, und Widerstände. Die gedruckten Systeme zeigen eine bessere Qualität durch weniger Prozessschritte bzw. optimierte Prozessschritte. Das Verfahren ermöglicht beispielsweise die kontinuierliche Herstellung von Siliconelastomer-Elektronik sowie optimale Elektroden in Bezug auf Ladungsflächen und Flexibilität.

### Abbildungen

Figur 1 zeigt eine Rolle-zu-Rolle-Prozessskizze zur Herstellung von Siliconelastomer-Mehrschichtsystemen.
Figur 2 zeigt eine Prozessskizze zur Herstellung von Siliconelastomer-Mehrschichtsystemen mithilfe eines Umlaufbands.
Figur 3 zeigt eine Skizze des Lasertransferprozesses.
Figur 4 zeigt eine Skizze zur Beauftragung eines für den Lasertransfer-Druck geeigneten Druckmassenträgers mit einer Siliconzusammensetzung.
Figur 5 zeigt eine Skizze des Ablösemechanismus einer Siliconfolie von einem Folienträger mithilfe von Flüssigkeiten.
Figur 6 zeigt den Aufbau einer Kompositelektrode.

### Beschreibung der Erfindung

Die Erfindung betrifft ein Verfahren zur Aufbringung wenigstens einer Siliconschicht mittels Laser-Transferdruck, wobei das Verfahren folgende Schritte umfasst:
(i) Bereitstellen einer Laserquelle;
(ii) Bereitstellen eines Druckmassenträgers unterhalb der Laserquelle , wobei der Druckmassenträger transparent für Laserstrahlung ist und auf der unteren Seite mit einer vernetzbaren Siliconzusammensetzung beschichtet ist und wenigstens die Oberfläche der vernetzbaren Siliconzusammensetzung auf ein Potential Phi_1 aufgeladen wird;
(iii) Bereitstellen eines Anlagenträgers unterhalb des Druckmassenträgers;
(iv) Bereitstellen einer Elektrode unterhalb des Anlagenträgers, wobei die Elektrode auf ein Potential Phi_3 aufgeladen wird, wobei Phi_1 und Phi_3 entgegengesetzte Polaritäten aufweisen;
(v) Bestrahlung des Druckmassenträgers mit Laserstrahlen, so dass wenigstens ein Teil der vernetzbaren Siliconzusammensetzung abgelöst wird und auf den Anlagenträger transferiert wird; und
(vi) Ausbildung einer Siliconschicht durch vollständige oder teilweise Vernetzung der auf den Anlagenträger transferierten Siliconzusammensetzung.

Wobei im Rahmen der vorliegenden Erfindung Phi = Φ bedeutet.

Als Basismaterialien für die Siliconschicht können prinzipiell alle im Stand der Technik bekannten Siliconzusammensetzungen verwendet werden. Die Siliconzusammensetzung wird dabei vorzugsweise so gewählt, dass deren Vernetzung nicht schon durch Bestrahlung mit dem beim Lasertransferdruck eingesetzten Lasers ausgelöst wird. Bevorzugt handelt es sich um Siliconelastomerzusammensetzungen.

Es können beispielsweise additionsvernetzende, peroxidisch vernetzende, kondensationsvernetzende oder strahlenvernetzende Siliconelastomerzusammensetzungen verwendet werden. Bevorzugt sind peroxidisch oder additionsvernetzende Zusammensetzungen. Besonders bevorzugt sind additionsvernetzende Zusammensetzungen.

Die Siliconelastomerzusammensetzungen können ein- oder zweikomponentig formuliert sein. Die Vernetzung der Siliconelastomerzusammensetzungen erfolgt dabei durch Wärmezufuhr, UV-Licht und/oder Feuchtigkeit. Geeignet sind beispielsweise folgende Siliconelastomerzusammensetzungen: HTV (additionsvernetzend), HTV (strahlenvernetzend), LSR, RTV 2 (additionsvernetzend), RTV 2 (kondensations-vernetzend), RTV 1, TPSE (thermoplastisches Siliconelastomer), Thiol-En und Cyanacetamid vernetzende Systeme.

Die additionsvernetzenden Siliconzusammensetzungen enthalten im einfachsten Fall
(A) mindestens eine lineare Verbindung, die Reste mit aliphatischen Kohlenstoff-Kohlenstoff-Mehrfachbindungen aufweist,
(B) mindestens eine lineare Organopolysiloxan Verbindung mit Si-gebundenen Wasserstoffatomen,
   oder anstelle von (A) und (B) oder zusätzlich zu (A) und (B)
(C) mindestens eine lineare Organopolysiloxan Verbindung, die Si-C-gebundene Reste mit aliphatischen Kohlenstoff-Kohlenstoff Mehrfachbindungen und Si-gebundene Wasserstoffatome aufweist, und
(D) mindestens einen Hydrosilylierungskatalysator.

In einer besonderen Ausführungsform handelt es sich bei den Siliconzusammensetzungen um Siliconelastomerzusammensetzungen mit fluorierten Seitengruppen, wie sie beispielsweise in WO 2018/177523 A1 beschrieben sind. In dieser Ausführungsform enthalten Komponente (A), (B) und/oder (C) vorzugsweise wenigstens 2,5 mol %, besonders bevorzugt wenigstens 5 Mol% fluorierte Seitengruppen, wie beispielweise 3,3,3-Trifluorpropylmethylsiloxy- und/oder Bis(3,3,3-Trifluorpropyl)siloxy-gruppen.

Bei den Siliconzusammensetzungen kann es sich um Einkomponenten-Siliconzusammensetzungen wie auch um Zweikomponenten-Siliconzusammensetzungen handeln. In letzterem Fall können die beiden Komponenten der erfindungsgemäßen Zusammensetzungen alle Bestandteile in beliebiger Kombination enthalten, im Allgemeinen mit der Maßgabe, dass eine Komponente nicht gleichzeitig Siloxane mit aliphatischer Mehrfachbindung, Siloxane mit Si-gebundenem Wasserstoff und Katalysator, also im Wesentlichen nicht gleichzeitig die Bestandteile (A), (B) und (D) bzw. (C) und (D) enthält.

Die in den erfindungsgemäßen Zusammensetzungen eingesetzten Verbindungen (A) und (B) bzw. (C) werden bekanntermaßen so gewählt, dass eine Vernetzung möglich ist. So weist beispielsweise Verbindung (A) mindestens zwei aliphatisch ungesättigte Reste auf und (B) mindestens drei Si-gebundene Wasserstoffatome, oder Verbindung (A) weist mindestens drei aliphatisch ungesättigte Reste auf und Siloxan (B) mindestens zwei Si-gebundene Wasserstoffatome, oder aber anstelle von Verbindung (A) und (B) wird Siloxan (C) eingesetzt, welches aliphatisch ungesättigte Reste und Si-gebundene Wasserstoffatome in den oben genannten Verhältnissen aufweist. Auch geeignet sind Mischungen aus (A) und (B) und (C) mit den oben genannten Verhältnissen von aliphatisch ungesättigten Resten und Si-gebundenen Wasserstoffatomen.

Bei der erfindungsgemäß eingesetzten Verbindung (A) kann es sich um siliciumfreie organische Verbindungen mit vorzugsweise mindestens zwei aliphatisch ungesättigten Gruppen sowie um Organosiliciumverbindungen mit vorzugsweise mindestens zwei aliphatisch ungesättigten Gruppen handeln oder auch um deren Mischungen.

Beispiele für siliciumfreie organische Verbindungen (A) sind, 1,3,5-Trivinylcyclohexan, 2,3-Dimethyl-1,3-butadien, 7-Methyl-3-methylen-1,6-octadien, 2-Methyl-1,3-butadien, 1,5-Hexadien, 1,7-Octadien, 4,7-Methylen-4,7,8,9-tetrahydroinden, Methylcyclopentadien, 5-Vinyl-2-norbornen, Bicyclo[2.2.1]hepta-2,5-dien, 1,3-Diisoproppenylbenzol, vinylgruppenhaltiges Polybutadien, 1,4-Divinylcyclohexan, 1,3,5-Triallylbenzol, 1,3,5-Trivinylbenzol, 1,2,4-Trivinylcyclohexan, 1,3,5-Triisoproppenylbenzol, 1,4-Divinylbenzol, 3-Methyl-heptadien-(1,5), 3-Phenylhexadien-(1,5), 3-Vinyl-hexadien-(1,5 und 4,5-Dimethyl-4,5-diethyl-octadien-(1,7), N,N'-Methylen-bis-acrylsäureamid, 1,1,1-Tris(hydroxymethyl)-propan-triacrylat, 1,1,1-Tris(hydroxymethyl)propantrimethacrylat, Tripropylenglykol-diacrylat, Diallylether, Diallylamin, Diallylcarbonat, N,N'-Diallylharnstoff, Triallylamin, Tris(2-methylallyl)amin, 2,4,6-Triallyloxy-1,3,5-triazin, Triallyl-s-triazin-2,4,6(1H,3H,5H)-trion, Diallylmalonsäureester, Polyethylenglykoldiacrylat, Polyethylenglykol Dimethacrylat, Poly(propylenglykol)methacrylat.

Vorzugsweise enthalten die erfindungsgemäßen Siliconzusammensetzungen als Bestandteil (A) mindestens eine aliphatisch ungesättigte Organosiliciumverbindung, wobei alle bisher in additionsvernetzenden Zusammensetzungen verwendeten, aliphatisch ungesättigten Organosiliciumverbindungen eingesetzt werden können, wie beispielsweise Silicon-Blockcopolymere mit Harnstoffsegmenten, Silicon-Blockcopolymere mit Amid-Segmenten und/oder Imid-Segmenten und/oder Ester-Amid-Segmenten und/oder Polystyrol-Segmenten und/oder Silarylen-Segmenten und/oder Carboran-Segmenten und Silicon-Pfropfcopolymere mit Ether-Gruppen.

Als Organosiliciumverbindungen (A), die Si-C-gebundene Reste mit aliphatischen Kohlenstoff-Kohlenstoff-Mehrfachbindungen aufweisen, werden vorzugsweise lineare oder verzweigte Organopolysiloxane aus Einheiten der allgemeinen Formel (I)

R⁴aR⁵_{b}SiO_{(4-a-b)/2} (I)

eingesetzt, wobei
R⁴ unabhängig voneinander, gleich oder verschieden, ein von aliphatischen Kohlenstoff-Kohlenstoff-Mehrfachbindungen freien, organischen oder anorganischen Rest,
R⁵ unabhängig voneinander, gleich oder verschieden einen einwertigen, substituierten oder nicht substituierten, Si-C-gebundenen Kohlenwasserstoffrest mit mindestens einer aliphatischen Kohlenstoff-Kohlenstoff-Mehrfachbindung,
a 0, 1, 2 oder 3 ist, und
b 0, 1 oder 2 ist
bedeuten, mit der Maßgabe, dass die Summe a + b kleiner oder gleich 3 ist und mindestens 2 Reste R⁵ je Molekül vorliegen.

Bei Rest R⁴ kann es sich um ein- oder mehrwertige Reste handeln, wobei die mehrwertigen Reste, wie beispielsweise bivalente, trivalente und tetravalente Reste, dann mehrere, wie etwa zwei, drei oder vier, Siloxy-Einheiten der Formel (I) miteinander verbinden.

Weitere Beispiele für R⁴ sind die einwertigen Reste -F, -Cl, -Br,-OR⁶, -CN, -SCN,-NCO und Si-C-gebundene, substituierte oder nicht substituierte Kohlenwasserstoffreste, die mit Sauerstoffatomen oder der Gruppe -C(O)-unterbrochen sein können, sowie zweiwertige, beidseitig gemäß Formel (I) Si-gebundene Reste. Falls es sich bei Rest R⁴ um Si-C-gebundene, substituierte Kohlenwasserstoffreste handelt, sind bevorzugte Substituenten Halogenatome, phosphorhaltige Reste, Cyanoreste, -OR⁶, -NR⁶-, -NR⁶₂, -NR⁶-C(O)-NR⁶₂, -C(O)-NR⁶₂, -C(O)R⁶, -C(O)OR⁶, -SO₂-Ph und -C₆F₅. Dabei bedeuten R⁶ unabhängig voneinander, gleich oder verschieden ein Wasserstoffatom oder einen einwertigen Kohlenwasserstoffrest mit 1 bis 20 Kohlenstoffatomen und Ph gleich dem Phenylrest.

Beispiele für Reste R⁴ sind Alkylreste, wie der Methyl-, Ethyl-, n-Propyl-, iso-Propyl-, n-Butyl-, iso-Butyl-, tert-Butyl-, n-Pentyl-, iso-Pentyl-, neo-Pentyl-, tert-Pentylrest, Hexylreste, wie der n-Hexylrest, Heptylreste, wie der n-Heptylrest, Octylreste, wie der n-Octylrest und iso-Octylreste, wie der 2,2,4-Trimethylpentylrest, Nonylreste, wie der n-Nonylrest, Decylreste, wie der n-Decylrest, Dodecylreste, wie der n-Dodecylrest, und Octadecylreste, wie der n-Octadecylrest, Cycloalkylreste, wie Cyclopentyl-, Cyclohexyl-, Cycloheptyl- und Methylcyclohexylreste, Arylreste, wie der Phenyl-, Naphthyl-, Anthryl- und Phenanthrylrest, Alkarylreste, wie o-, m-, p-Tolylreste, Xylylreste und Ethylphenylreste, und Aralkylreste, wie der Benzylrest, der α- und der β-Phenylethylrest.

Beispiele für substituierte Reste R⁴ sind Halogenalkylreste, wie der 3,3,3-Trifluor-n-propylrest, der 2,2,2,2',2',2'-Hexafluorisopropylrest, der Heptafluorisopropylrest, Halogenarylreste, wie der o-, m- und p-Chlorphenylrest, -(CH₂)-N(R⁶)C(O)NR⁶₂,-(CH₂)ₙ-C(O)NR⁶₂, -(CH₂)ₒ-C(O)R⁶, -(CH₂)ₒ-C(O)OR⁶, -(CH₂)ₒ-C(O)NR⁶₂, -(CH₂)-C(O)-(CH₂)ₚC(O)CH₃, -(CH₂)-O-CO-R⁶, -(CH₂)-NR⁶-(CH₂)ₚ-NR⁶₂, -(CH₂)ₒ-O-(CH₂)ₚCH (OH) CH₂OH, -(CH₂)ₒ(OCH₂CH₂)ₚOR⁶, -(CH₂)ₒ-SO₂-Ph und -(CH₂)ₒ-O-C₆F₅, wobei R⁶ und Ph der oben dafür angegebene Bedeutung entsprechen und o und p gleiche oder verschiedene ganze Zahlen zwischen 0 und 10 bedeuten.

Beispiele für R⁴ gleich zweiwertige, beidseitig gemäß Formel (I) Si-gebundene Reste sind solche, die sich von den voranstehend für Rest R⁴ genannten einwertigen Beispiele dadurch ableiten, dass eine zusätzliche Bindung durch Substitution eines Wasserstoffatoms erfolgt, Beispiele für derartige Reste sind -(CH₂)-, -CH(CH₃)-,-C(CH₃)₂-, -CH(CH₃)-CH₂-, -C₆H₄-, -CH(Ph)-CH₂-, -C(CF₃)₂-, -(CH₂)ₒ-C₆H₄-(CH₂)ₒ-,-(CH₂)ₒ-C₆H₄-C₆H₄-(CH₂)ₒ-, -(CH₂O)ₚ, (CH₂CH₂O)ₒ, -(CH₂)ₒ-Oₓ-C₆H₄-SO₂-C₆H₄-Oₓ-(CH₂)ₒ-, wobei x 0 oder 1 ist, und Ph, o und p die voranstehend genannte Bedeutung haben.

Bevorzugt handelt es sich bei Rest R⁴ um einen einwertigen, von aliphatischen Kohlenstoff-Kohlenstoff-Mehrfachbindungen freien, Si-C-gebundenen, gegebenenfalls substituierten Kohlenwasserstoffrest mit 1 bis 18 Kohlenstoffatomen, besonders bevorzugt um einen einwertigen, von aliphatischen Kohlenstoff-Kohlenstoff-Mehrfachbindungen freien, Si-C-gebundenen Kohlenwasserstoffrest mit 1 bis 6 Kohlenstoffatomen, insbesondere um den Methyl- oder Phenylrest.

Bei Rest R⁵ aus Formel (I) kann es sich um beliebige, einer Anlagerungsreaktion (Hydrosilylierung) mit einer SiH-funktionellen Verbindung zugängliche Gruppen handeln.

Falls es sich bei Rest R⁵ um Si-C-gebundene, substituierte Kohlenwasserstoffreste handelt, sind als Substituenten Halogenatome, Cyanoreste und -OR⁶ bevorzugt, wobei R⁶ die obengenannte Bedeutung hat.

Bevorzugt handelt es sich bei Rest R⁵ um Alkenyl- und Alkinylgruppen mit 2 bis 16 Kohlenstoffatomen, wie Vinyl-, Allyl-, Methallyl-, 1-Propenyl-, 5-Hexenyl-, Ethinyl-, Butadienyl-, Hexadienyl-, Cyclopentenyl-, Cyclopentadienyl-, Cyclohexenyl-, Vinylcyclohexylethyl-, Divinylcyclohexylethyl-, Norbornenyl-, Vinylphenyl- und Styrylreste, wobei Vinyl-, Allyl- und Hexenylreste besonders bevorzugt verwendet werden.

Das Molekulargewicht des Bestandteils (A) kann in weiten Grenzen variieren, etwa zwischen 10² und 10⁶ g/mol. So kann es sich bei dem Bestandteil (A) beispielsweise um ein relativ niedermolekulares alkenylfunktionelles Oligosiloxan, wie 1,2-Divinyltetramethyldisiloxan, handeln, jedoch auch um ein über kettenständige oder endständige Si-gebundene Vinylgruppen verfügendes hochpolymeres Polydimethylsiloxan, z.B. mit einem Molekulargewicht von 10⁵ g/mol (mittels NMR bestimmtes Zahlenmittel). Auch die Struktur der den Bestandteil (A) bildenden Moleküle ist nicht festgelegt; insbesondere kann die Struktur eines höhermolekularen, also oligomeren oder polymeren Siloxans linear, cyclisch, verzweigt oder auch harzartig, netzwerkartig sein. Lineare und cyclische Polysiloxane sind vorzugsweise aus Einheiten der Formel R⁴₃SiO_{1/2}, R⁵R⁴₂SiO_{1/2}, R⁵R⁴SiO_{1/2} und R⁴₂SiO_{2/2} zusammengesetzt, wobei R⁴ und R⁵ die vorstehend angegebene Bedeutung haben. Verzweigte und netzwerkartige Polysiloxane enthalten zusätzlich trifunktionelle und/oder tetrafunktionelle Einheiten, wobei solche der Formeln R⁴SiO_{3/2}, R⁵SiO_{3/2} und SiO_{4/2} bevorzugt sind. Selbstverständlich können auch Mischungen unterschiedlicher, den Kriterien des Bestandteils (A) genügender Siloxane eingesetzt werden.

Besonders bevorzugt als Komponente (A) ist die Verwendung vinylfunktioneller, im wesentlichen linearer Polydiorganosiloxane mit einer Viskosität von 0,01 bis 500.000 Pa·s, besonders bevorzugt von 0,1 bis 100.000 Pa·s, jeweils bei 25°C, gemessen nach DIN EN ISO 3219: 1994 und DIN 53019 mittels eines kalibrierten Rheometers mit einem Kegel-Platte-System, Kegel CP50-2 mit einem Öffnungswinkel von 2° und einer Scherrate von 1 s⁻¹.

Als Organosiliciumverbindungen (B) können alle hydrogenfunktionellen Organosiliciumverbindungen eingesetzt werden, die auch bisher in additionsvernetzbaren Zusammensetzungen eingesetzt worden sind.

Als Organopolysiloxane (B), die Si-gebundene Wasserstoffatome aufweisen, werden vorzugsweise lineare, cyclische oder verzweigte Organopolysiloxane aus Einheiten der allgemeinen Formel (III)

R⁴_{c}H_{d}SiO_{(4-c-d)/2} (III)

eingesetzt, wobei
R⁴ die oben angegebene Bedeutung hat,
c 0,1,2 oder 3 ist und
d 0, 1 oder 2 ist,
mit der Maßgabe, dass die Summe von c + d kleiner oder gleich 3 ist und mindestens zwei Si gebundene Wasserstoffatome je Molekül vorliegen.

Vorzugsweise enthält das erfindungsgemäß eingesetzte Organopolysiloxan (B) Si-gebundenen Wasserstoff im Bereich von 0,04 bis 1,7 Gewichtsprozent, bezogen auf das Gesamtgewicht des Organopolysiloxans (B).

Das Molekulargewicht des Bestandteils (B) kann ebenfalls in weiten Grenzen variieren, etwa zwischen 10² und 10⁶ g/mol. So kann es sich bei dem Bestandteil (B) beispielsweise um ein relativ niedermolekulares SiH-funktionelles Oligosiloxan, wie Tetramethyldisiloxan, handeln, jedoch auch um ein über kettenständig oder endständig SiH-Gruppen verfügendes hochpolymeres Polydimethylsiloxan oder ein SiH-Gruppen aufweisendes Siliconharz.

Auch die Struktur der den Bestandteil (B) bildenden Moleküle ist nicht festgelegt; insbesondere kann die Struktur eines höhermolekularen, also oligomeren oder polymeren SiH-haltigen Siloxans linear, cyclisch, verzweigt oder auch harzartig, netzwerkartig sein. Lineare und cyclische Polysiloxane (B) sind vorzugsweise aus Einheiten der Formel R⁴₃SiO_{1/2}, HR⁴₂SiO_{1/2}, HR⁴SiO_{2/2} und R⁴₂SiO_{2/2} zusammengesetzt, wobei R⁴ die vorstehend angegebene Bedeutung hat. Verzweigte und netzwerkartige Polysiloxane enthalten zusätzlich trifunktionelle und/oder tetrafunktionelle Einheiten, wobei solche der Formeln R⁴SiO_{3/2}, HSiO_{3/2} und SiO_{4/2} bevorzugt sind, wobei R⁴ die vorstehend angegebene Bedeutung hat.

Selbstverständlich können auch Mischungen unterschiedlicher, den Kriterien des Bestandteils (B) genügender Siloxane eingesetzt werden. Insbesondere können die den Bestandteil (B) bildenden Moleküle zusätzlich zu den obligaten SiH-Gruppen ggf. zugleich auch aliphatisch ungesättigte Gruppen enthalten. Besonders bevorzugt ist die Verwendung niedermolekularer SiH-funktioneller Verbindungen wie Tetrakis(dimethylsiloxy)silan und Tetramethylcyclotetrasiloxan, sowie höhermolekularer, SiH-haltiger Siloxane, wie Poly(hydrogenmethyl)siloxan und Poly(dimethylhydrogenmethyl)siloxan mit einer Viskosität bei 25°C von 10 bis 20.000 mPa·s, gemessen nach DIN EN ISO 3219: 1994 und DIN 53019 mittels eines kalibrierten Rheometers mit einem Kegel-Platte-System, Kegel CP50-2 mit einem Öffnungswinkel von 2° und einer Scherrate von 1 s⁻¹, oder analoge SiH-haltige Verbindungen, bei denen ein Teil der Methylgruppen durch 3,3,3-Trifluorpropyl- oder Phenylgruppen ersetzt ist.

Bestandteil (B) ist vorzugsweise in einer solchen Menge in den erfindungsgemäßen vernetzbaren Siliconzusammensetzungen enthalten, dass das Molverhältnis von SiH-Gruppen zu aliphatisch ungesättigten Gruppen aus (A) bei 0,1 bis 20, besonders bevorzugt zwischen 0,3 und 2,0 liegt.

Die erfindungsgemäß eingesetzten Komponenten (A) und (B) sind handelsübliche Produkte bzw. nach gängigen Verfahren herstellbar.

Anstelle von Komponente (A) und (B) können die erfindungsgemäßen Siliconzusammensetzungen Organopolysiloxane (C), die gleichzeitig aliphatische Kohlenstoff-Kohlenstoff-Mehrfachbindungen und Si-gebundene Wasserstoffatome aufweisen, enthalten. Auch können die erfindungsgemäßen Siliconzusammensetzungen alle drei Komponenten (A), (B) und (C) enthalten.

Falls Siloxane (C) eingesetzt werden, handelt es sich vorzugsweise um solche aus Einheiten der allgemeinen Formeln (IV), (V) und (VI)

R⁴_{f}SiO_{4/2} (IV)

R⁴_{g}R⁵SiO_{3-g/2} (V)

R⁴ₕHSiO_{3-h/2} (VI)

wobei
R⁴ und R⁵ die oben dafür angegebene Bedeutung haben
f 0, 1, 2 oder 3 ist,
g 0, 1 oder 2 ist und
h 0, 1 oder 2 ist,
mit der Maßgabe, dass je Molekül mindestens zwei Reste R⁵ und mindestens zwei Si-gebundene Wasserstoffatome vorliegen.

Beispiele für Organopolysiloxane (C) sind solche aus Si04/2, R⁴₃SiO_{1/2}-, R⁴₂R⁵SiO_{1/2}- und R⁴₂HSiO_{1/2}- Einheiten, sogenannte MP-Harze, wobei diese Harze zusätzlich R⁴SiO_{3/2}- und R⁴₂SiO-Einheiten enthalten können, sowie lineare Organopolysiloxane im Wesentlichen bestehend aus R⁴₂R⁵SiO_{1/2}-, R⁴₂SiO- und R⁴HSiO-Einheiten mit R⁴ und R⁵ gleich der obengenannten Bedeutung.

Die Organopolysiloxane (C) besitzen vorzugsweise eine durchschnittliche Viskosität von 0,01 bis 500.000 Pa·s, besonders bevorzugt 0,1 bis 100.000 Pa·s jeweils bei 25°C, gemessen nach DIN EN ISO 3219: 1994 und DIN 53019 mittels eines kalibrierten Rheometers mit einem Kegel-Platte-System, Kegel CP50-2 mit einem Öffnungswinkel von 2° und einer Scherrate von 1 s⁻¹..

Organopolysiloxane (C) sind kommerziell erhältlich oder nach gängigen Methoden herstellbar.

Erfindungsgemäße additionsvernetzende Siliconzusammensetzungen, können ausgewählt werden aus der Gruppe enthaltend
- jeweils mindestens eine Verbindung (A), (B) und (D),
- jeweils mindestens eine Verbindung (C) und (D), und
- jeweils mindestens eine Verbindung (A), (B), (C) und (D),
wobei
(A) eine organische Verbindung oder eine Siliciumorganische Verbindung, enthaltend mindestens zwei Reste mit aliphatischen Kohlenstoff-Kohlenstoff-Mehrfachbindungen,
(B) ein Siliciumorganische Verbindung, enthaltend mindestens zwei Si-gebundenen Wasserstoffatome,
(C) eine Siliciumorganische Verbindung, enthaltend Si-C-gebundene Reste mit aliphatischen Kohlenstoff-Kohlenstoff-Mehrfachbindungen und Si- gebundene Wasserstoffatome, und
(D) ein Hydrosilylierungskatalysator
bedeuten.

Die Siliconzusammensetzung enthält üblicherweise 30-95 Gew.%, bevorzugt 30-80 Gew.% und besonders bevorzugt 40-70 Gew.% (A), basierend auf der Gesamtmasse der Siliconzusammensetzung.

Die Siliconzusammensetzung enthält üblicherweise 0,1 - 60 Gew.%, bevorzugt 0,5-50 Gew.% und besonders bevorzugt 1-30 Gew.% (B), basierend auf der Gesamtmasse der Siliconzusammensetzung.

Falls die Siliconzusammensetzung die Komponente (C) enthält, sind üblicherweise 30-95 Gew.%, bevorzugt 30-80 Gew.%, besonders bevorzugt 40-70 Gew.% (C) in der Formulierung enthalten, basierend auf der Gesamtmasse der Siliconzusammensetzung.

Die Menge an Komponente (D) kann zwischen 0,1 und 1000 Teile pro Million (ppm), 0,5 und 100 ppm oder 1 und 25 ppm des Platingruppenmetalls betragen, je nach Gesamtgewicht der Komponenten.

Die Mengen aller in der Siliconzusammensetzung vorliegenden Komponenten werden dabei so gewählt, dass sie in der Summe 100 Gew.%, basierend auf der Gesamtmasse der Siliconzusammensetzung, nicht überschreiten.

Als Hydrosilylierungskatalysator (D) können alle dem Stand der Technik bekannten Katalysatoren verwendet werden können. Komponente (D) kann ein Platingruppenmetall sein, beispielsweise Platin, Rhodium, Ruthenium, Palladium, Osmium oder Iridium, eine metallorganische Verbindung oder eine Kombination davon. Beispiele für Komponente (D) sind Verbindungen wie Hexachloroplatin(IV)-säure, Platindichlorid, Platinacetylacetonat und Komplexe der besagten Verbindungen, die in einer Matrix oder einer kernschalenartigen Struktur eingekapselt sind. Zu den Platinkomplexen mit niedrigem Molekulargewicht der Organopolysiloxane gehören 1,3-Diethenyl-1,1,3,3 - Tetramethyldisiloxan-Komplexe mit Platin. Weitere Beispiele sind Platinphosphitkomplexe, Platinphosphinkomplexe oder Alkylplatinkomplexe. Diese Verbindungen können in einer Harzmatrix eingekapselt sein.

Die Konzentration von Komponente (D) ist zum Katalysieren der Hydrosilylierungsreaktion der Komponenten (A) und (B) bei Einwirkung ausreichend, um die hier in dem beschriebenen Verfahren erforderliche Wärme zu erzeugen. Die Menge an Komponente (D) kann zwischen 0,1 und 1000 Teile pro Million (ppm), 0,5 und 100 ppm oder 1 und 25 ppm des Platingruppenmetalls betragen, je nach Gesamtgewicht der Komponenten. Die Härtungsrate kann gering sein, wenn der Bestandteil des Platingruppenmetalls bei unter 1 ppm liegt. Die Verwendung von mehr als 100 ppm des Platingruppenmetalls ist unwirtschaftlich oder kann die Stabilität der Kleberformulierung verringern.

Bevorzugt enthält die Siliconzusammensetzung Platinkomplexe der allgemeinen Formel (VII)

R³₃Pt{CpR⁴₅₋ᵣ₋ₜ[(CR₂)ₙSiR¹ₒR²ₚ]ₜ[SiR⁷ₛR⁸₃₋ₛ]ᵣ} (VII),

wobei in Formel (VII)
**Cp** Cyclopentadienylrest bedeutet,
**n** eine ganze Zahl von 1 bis 8 ist,
**o** 0, 1, 2 oder 3 ist,
**p** 0, 1, 2 oder 3 ist, mit der Maßgabe, dass **o+p=3** ist,
**r** 1, 2, 3, 4 oder 5, bevorzugt 1, 2 oder 3, besonders bevorzugt 1 oder 2, insbesondere 1, ist,
**t** 0, 1, 2, 3 oder 4, bevorzugt 0 oder 1, besonders bevorzugt 1, ist, mit der Maßgabe, dass **r+t≤5**, bevorzugt 3, ist,
**s** 0, 1 oder 2, bevorzugt 2, ist,
**R** gleich oder verschieden sein kann und Wasserstoffatom oder einen monovalenten, unsubstituierten oder substituierten Kohlenwasserstoffrest bedeutet,
**R¹** gleich oder verschieden sein kann und einen monovalenten, unsubstituierten oder substituierten Kohlenwasserstoffrest, der durch Heteroatome unterbrochen sein kann, bedeutet,
**R²** gleich oder verschieden sein kann und hydrolysierbare Gruppe oder einen über Sauerstoff angebundenen Siloxyrest bedeutet,
**R⁷** gleich oder verschieden sein kann und einen monovalenten, unsubstituierten oder substituierten, aliphatisch gesättigten Kohlenwasserstoffrest, der durch Heteroatome unterbrochen sein kann, oder einen über Sauerstoff angebundenen Siloxyrest bedeutet,
**R⁸** gleich oder verschieden sein kann und einen aliphatisch ungesättigten, gegebenenfalls substituierten Rest darstellt,
**R³** gleich oder verschieden sein kann und einen monovalenten, unsubstituierten oder substituierten aliphatisch gesättigten Kohlenwasserstoffrest bedeutet,
**R⁴** gleich oder verschieden sein kann, Wasserstoffatom, SiC-gebundener Silylrest oder einen unsubstituierten oder substituierten Kohlenwasserstoffrest bedeutet, der durch Heteroatome unterbrochen sein kann.

Beispiele für solche Platinkomplexe der Formel (VII) sind
- Trimethyl[(allyldimethylsilyl)cyclopentadienyl]-platin(IV),
- Trimethyl[((2-methyl-allyl)dimethylsilyl)cyclopentadienyl]-platin(IV),
- Trimethyl[(trimethoxysilyl)methyl-(allyldimethylsilyl)cyclopentadienyl]-platin(IV),
- Trimethyl[(2-trimethoxysilyl)ethyl-(allyldimethylsilyl)cyclopentadienyl]-platin(IV),
- Trimethyl[(3-trimethoxysilyl)propyl-(allyldimethylsilyl)cyclopentadienyl]-platin(IV),
- Trimethyl[(3-dimethoxymethylsilyl)propyl-(allyldimethylsilyl)cyclopentadienyl]-platin(IV),
- Trimethyl[(4-trimethoxysilyl)butyl-(allyldimethylsilyl)cyclopentadienyl]-platin(IV),
- Trimethyl[(2-trimethoxysilyl)-1-methyl-ethyl-(allyldimethylsilyl)cyclopentadienyl]-platin(IV),
- Trimethyl[(3-trimethoxysilyl)-2-methyl-2-propyl-(allyldimethylsilyl)cyclopentadienyl]-platin(IV),
- Trimethyl[bis(allyldimethylsilyl)cyclopentadienyl]-platin(IV),
- Trimethyl[bis(2-methyl-allyldimethylsilyl)cyclopentadienyl]-platin(IV),
- Trimethyl[(trimethoxysilyl)methyl-bis(allyldimethylsilyl)cyclopentadienyl]-platin(IV),
- Trimethyl[(2-trimethoxysilyl)ethyl-bis(allyldimethylsilyl)cyclopentadienyl]-platin(IV),
- Trimethyl[(3-trimethoxysilyl)propyl-bis(allyldimethylsilyl)cyclopentadienyl]-platin(IV),
- Trimethyl[(4-trimethoxysilyl)butyl-bis(allyldimethylsilyl)cyclopentadienyl]-platin(IV),
- Trimethyl[(2-trimethoxysilyl)-1-methyl-ethyl-bis(allyldimethylsilyl)cyclopentadienyl]-platin(IV),
- Trimethyl[(3-trimethoxysilyl)-2-methyl-2-propyl-bis(allyldimethylsilyl)cyclopentadienyl]-platin(IV),
- Trimethyl[tris(allyldimethylsilyl)cyclopentadienyl]-platin(IV),
- Trimethyl[(triethoxysilyl)methyl-(allyldimethylsilyl)cyclopentadienyl]-platin(IV),
- Trimethyl[(triacetoxysilyl)methyl-(allyldimethylsilyl)cyclopentadienyl]-platin(IV),
- Trimethyl[(3-bis-trimethylsiloxy)methylsilylpropyl](allyldimethylsilyl) cyclopentadienyl-platin(IV),
- Trimethyl[(3-triethoxysi]yl)propyl-(allyldimethylsilyl)cyclopentadienyl]-platin(IV),
- Trimethyl[(triethoxysilyl)methyl-bis(ailyldimethylsilyl)cyclopentadienyl]-platin(IV),
- Trimethyl[(3-triethoxysilyl)propyl-bis(allyldimethylsilyl)cyclopentadienyl]-platin(IV),
- Trimethyl[(triethoxysilyl)methyl-tris(allyldimethylsilyl)cyclopentadienyl]-platin(IV),
- Triethyl[(allyldimethylsilyl)cyclopentadienyl]-platin(IV),
- Tris(trimethylsilylmethyl)[(allyldimethylsilyl)cyclopentadienyl]-platin(IV),
- Triethyl[(trimethoxysilyl)methyl-(allyldimethylsilyl)cyclopentadienyl]-platin(IV),
- Triethyl[(trimethoxysilyl)methyl-bis(allyldimethylsilyl)cyclopentadienyl]-platin(IV),
- Triethyl[tris(allyldimethylsilyl)cyclopentadienyl]-platin(IV) und
- Triethyl[(trimethoxysilyl)methyl-tris(allyldimethylsilyl)cyclopentadienyl]-platin(IV).

Diese Platinkomplexe sind beispielsweise in WO 2016/030325 A1 beschrieben.

In einer weiteren Ausführungsform handelt es sich bei den Siliconzusammensetzungen um peroxidisch vernetzbare Siliconmassen. Diese Siliconmassen können durch die Zugabe organischer Peroxide (als Komponente D) organisch vernetzt werden. In diesem Fall besteht die Siliconzusammensetzung mindestens aus den Komponenten (A) und (D). Dabei sind bevorzugt zwischen 0,1 und 20 Gew.-% Komponente (D) in den erfindungsgemäßen Siliconkautschukmassen enthalten. Als Vernetzer im Sinne der Komponente (D) können alle dem Stand der Technik entsprechenden und typischen Peroxide verwendet werden. Beispiele für die Komponente (D) sind Dialkylperoxide, wie 2,5-Dimethyl-2,5-di(tert-butylperoxy)hexan, 1,1-Di-(tertbutylperoxy)-cyclohexan, 1,1-Di-(tert-butylperoxy)-3,3,5-trimethylcyclohexan, a-Hydroxyperoxy-a'-hydroxydicyclohexylperoxid, 3,6-Dicyclohexyliden-1 ,2,4,5-tetroxan, Di-tert-butylperoxid, tert-Butyl-tert-triptylperoxid und tert-Butyl-triethyl- 5-methylperoxid, Diaralkylperoxide, wie Dicumylperoxid, Alkylaralkylperoxide, wie tert-Butylcumylperoxid und a,a'-di(tert- Butylperoxy)-m/p-diisopropylbenzol, Alkylacylperoxide, wie t-Butylperbenzoat, und Diacylperoxide, wie Dibenzoylperoxid, Bis-(2-methylbenzoylperoxid), Bis-(4-methylbenzoylperoxid) und Bis-(2,4-dichlorbenzoylperoxid). Bevorzugt ist die Verwendung vinylspezifischer Peroxide, deren wichtigste Vertreter die Dialkyl- und Diaralkylperoxide sind. Besonders bevorzugt ist die Verwendung von 2,5-Dimethyl-2,5-di(tert-butylperoxy)hexan und Dicumylperoxid. Es können einzelne Peroxide oder Mischungen unterschiedlicher Peroxide eingesetzt werden. Der Gehalt der peroxidisch vernetzbaren Siliconkautschukmasse an Bestandteil (D) liegt vorzugsweise zwischen 0,1 und 5,0 Gew.-%, besonders bevorzugt zwischen 0,5 und 1,5 Gew.-%. Bevorzugt sind somit die erfindungsgemäßen, vernetzbaren Siliconkautschukmassen, dadurch gekennzeichnet, dass der Vernetzer (D) von 0,1 bis 5,0 Gewichts-% enthalten ist und ein organisches Peroxid oder eine Mischung aus organischen Peroxiden darstellt, jeweils basierend auf der Gesamtmasse der Siliconzusammensetzung.

Die beschriebenen Massen können optional alle weiteren Zusatzstoffe enthalten, die auch bisher zur Herstellung von peroxid- und additionsvernetzbaren Zusammensetzungen eingesetzt wurden.

Diese Zusatzstoffe können auch allen im Stand der Technik bekannten kondensationsvernetzenden Siliconelastomerzusammensetzungen zugesetzt werden. Eine nähere Beschreibung der Vernetzungsart ist beispielsweise in EP 0787766 A1 beschrieben.

Zu den Beispielen für optionale Komponenten gehören unter anderem (E) Füllstoffe.

Beispiele für verstärkende Füllstoffe, die als Komponente in den erfindungsgemäßen Siliconzusammensetzungen eingesetzt werden können, sind pyrogene oder gefällte Kieselsäuren mit BET-Oberflächen von mindestens 50 m²/g sowie Ruße und Aktivkohlen wie Furnace-Ruß und Acetylen-Ruß, wobei pyrogene und gefällte Kieselsäuren mit BET-Oberflächen von mindestens 50 m²/g bevorzugt sind. Die genannten Kieselsäurefüllstoffe können hydrophilen Charakter haben oder nach bekannten Verfahren hydrophobiert sein. Der Gehalt der vernetzbaren Zusammensetzung an aktiv verstärkendem Füllstoff liegt im Bereich von 0 bis 70 Gew.-%, vorzugsweise bei 0 bis 50 Gew.-%, basierend auf der Gesamtmasse der Siliconzusammensetzung.

Besonders bevorzugt sind die vernetzbaren Siliconkautschukmassen dadurch gekennzeichnet, dass der Füllstoff (E) oberflächenbehandelt ist. Die Oberflächenbehandlung wird durch dem Stand der Technik bekannten Verfahren zur Hydrophobierung feinteiliger Füllstoffe erzielt. Die Hydrophobierung kann beispielsweise entweder vor der Einarbeitung in das Polyorganosiloxan erfolgen oder auch in Gegenwart eines Polyorganosiloxans nach dem in-situ Verfahren. Beide Verfahren können sowohl im Batch-Prozess als auch kontinuierlich durchgeführt werden. Bevorzugt verwendete Hydrophobierungsmittel sind siliciumorganische Verbindungen, die mit der Füllstoffoberfläche unter Ausbildung kovalenter Bindungen zu reagieren vermögen oder dauerhaft an der Füllstoffoberfläche physisorbiert werden. Beispiele für Hydrophobierungsmittel sind Alkylchlorsilane, wie Methyltrichlorsilan, Dimethyldichlorsilan, Trimethylchlorsilan, Octyltrichlorsilan, Octadecyltrichlorsilan, Octylmethyldichlorsilan, Octadecylmethyldichlorsilan, Octyldimethylchlorsilan, Octadecyldimethylchlorsilan und tert.-Butyldimethylchlorsilan; Alkylalkoxysilane, wie Dimethyldimethoxysilan, Dimethyldiethoxysilan, Trimethylmethoxysilan und Trimethylethoxysilan; Trimethylsilanol; zyklische Diorgano(poly)siloxane, wie Octamethylcyclotetrasiloxan, Dekamethylcyclopentasiloxan; lineare Diorganopolysiloxane, wie Dimethylpolysiloxane mit Trimethylsiloxy-Endgruppen sowie Dimethylpolysiloxane mit Silanol- oder Alkoxy-Endgruppen; Disilazane, wie Hexaalkyldisilazane, insbesondere Hexamethyldisilazan, Divinyltetramethyldisilazan, Bis(trifluorpropyl)tetramethyldisilazan; zyklische Dimethylsilazane, wie Hexamethylcyclotrisilazan. Es können auch Mischungen der weiter oben genannten Hydrophobierungsmittel eingesetzt werden. Um die Hydrophobierung zu beschleunigen, erfolgt gegebenenfalls auch der Zusatz von katalytisch aktiven Additiven, wie beispielsweise Aminen, Metallhydroxiden und Wasser.

Die Hydrophobierung kann beispielsweise in einem Schritt unter Verwendung von einem oder einer Mischung aus mehreren Hydrophobiermitteln, aber auch unter Verwendung von einem oder mehreren Hydrophobiermitteln in mehreren Schritten erfolgen.

Bevorzugte Füllstoffe (E) weisen infolge einer Oberflächenbehandlung einen Kohlenstoffgehalt von mindestens 0,01 bis maximal 20 Gew.-%, bevorzugt zwischen 0.1 und 10 Gew.-%, besonders bevorzugt zwischen 0,5 bis 5 Gew.-% auf, basierend auf der Gesamtmasse der Siliconzusammensetzung. Besonders bevorzugt sind vernetzbare Siliconkautschukmassen die dadurch gekennzeichnet sind, dass der Füllstoff (E) eine oberflächenbehandelte Kieselsäure, aufweisend 0,01 bis 2 Gew.-% Si-gebundene, aliphatisch ungesättigte Gruppen bedeutet, basierend auf der Gesamtmasse des Füllstoffes. Beispielsweise handelt es sich bei diesen um Si-gebundene Vinylgruppen. In der erfindungsgemäßen Siliconkautschukmasse wird der Bestandteil (E) bevorzugt als einzelne oder ebenfalls bevorzugt als eine Mischung mehrerer feinteiliger Füllstoffe verwendet.

Die erfindungsgemäße Siliconzusammensetzung kann wahlweise als Bestandteile weitere Zusätze zu einem Anteil von bis zu 70 Gew.-%, vorzugsweise 0,0001 bis 40 Gew.-%, enthalten, basierend auf der Gesamtmasse der Siliconzusammensetzung. Diese Zusätze können z.B. inaktive Füllstoffe, harzartige Polyorganosiloxane, die von den Siloxanen (A), (B) und (C) verschieden sind, verstärkende und nicht verstärkende Füllstoffe, Fungizide, Duftstoffe, rheologische Additive, Korrosionsinhibitoren, Oxidationsinhibitoren, Lichtschutzmittel, flammabweisend machende Mittel und Mittel zur Beeinflussung der elektrischen Eigenschaften Dispergierhilfsmittel, Lösungsmittel, Haftvermittler, Pigmente, Farbstoffe, Weichmacher, organische Polymere, Hitzestabilisatoren usw. sein. Hierzu zählen Zusätze, wie Quarzmehl, Diatomeenerde, Tone, Kreide, Lithopone, Ruße, Graphit, Graphen, Metalloxide, Metallcarbonate, -sulfate, Metallsalze von Carbonsäuren, Metallstäube, Fasern, Nanofasern, wie Glasfasern, Kunststoffasern, Kunststoffpulver, Farbstoffe, Pigmente usw..

Diese Füllstoffe können zudem wärmeleitend oder elektrisch leitend sein. Elektrische leitende Füllstoffe können beispielsweise eingesetzt werden um elektrisch leitende Siliconschichten herzustellen, welche wiederum als Elektrodenschicht in Sensoren, Aktoren oder anderen EAP-Systemen dienen können. Beispiele für wärmeleitende Füllstoffe sind Aluminiumnitrid; Aluminumoxid; Bariumtitanat; Berylliumoxid; Bornitrid; Diamant; Grafit; Magnesiumoxid; partikuläres Metall wie beispielsweise Kupfer, Gold, Nickel oder Silber; Siliciumcarbid; Wolframcarbid; Zinkoxid und/oder eine Kombination davon. Wärmeleitende Füllstoffe sind im Stand der Technik bekannt und im Handel erhältlich. Zum Beispiel CB-A20S und Al-43-Me sind Aluminiumoxid-Füllstoffe in verschiedenen Partikelgrößen, die im Handel bei Showa- Denko erhältlich sind, und AA-04, AA-2 und AAI 8 sind Aluminiumoxid-Füllstoffe, die im Handel bei Sumitomo Chemical Company erhältlich sind. Silber-Füllstoffe sind im Handel bei Metalor Technologies U.S.A. Corp. of Attleboro, Massachusetts, U.S.A., erhältlich. Bornitrid-Füllstoffe sind im Handel bei Advanced Ceramics Corporation, Cleveland, Ohio, U.S.A., erhältlich.

Zu den Verstärkungsfüllstoffen gehören Silica und Kurzfasern wie beispielsweise Kevlar®-Kurzfaser. Es können eine Kombination aus Füllstoffen mit verschiedenen Partikelgrößen und unterschiedlicher Partikelgrößenverteilung verwendet werden.

Die Siliconzusammensetzung kann weiterhin eine oder mehrere optionale Komponenten enthalten. Zu den Beispielen für optionale Komponenten gehören unter anderem (F) ein oder mehrere Lösungsmittel und (G) ein oder mehrere Inhibitoren.

Die Siliconzusammensetzung kann zusätzlich optional (F) ein oder mehrere Lösungsmittel enthalten. Es ist jedoch darauf zu achten, dass das Lösemittel keine nachteiligen Effekte auf das Gesamtsystem hat. Geeignete Lösungsmittel sind im Stand der Technik bekannt und im Handel erhältlich. Das Lösungsmittel kann beispielsweise ein organisches Lösungsmittel mit 3 bis 20 Kohlenstoffatomen sein. Zu den Beispielen für Lösungsmittel gehören aliphatische Kohlenwasserstoffe wie beispielsweise Nonan, Decalin und Dodecan; aromatische Kohlenwasserstoffe wie beispielsweise Mesitylen, Xylen und Toluen; Ester wie beispielsweise Ethylacetat und Butyrolacton; Ether wie beispielsweise n-Butylether und Polyethylenglycolmonomethylether; Ketone wie beispielsweise Methylisobutylketon und Methylpentylketon; Siliconfluid wie beispielsweise lineare, verzweigte und zyklische Polydimethylsiloxane und Kombinationen aus diesen Lösungsmitteln. Die optimale Konzentration eines bestimmten Lösungsmittels in einer Kleberformulierung kann durch Routineversuche leicht bestimmt werden. Je nach Gewicht der Verbindung kann die Menge des Lösungsmittels zwischen 0 und 95 % bzw. zwischen 1 und 95 % liegen, basierend auf dem Gesamtgewicht der Siliconzusammensetzung.

Inhibitoren (G) und Stabilisatoren dienen der gezielten Einstellung der Verarbeitungszeit, Anspringtemperatur und Vernetzungsgeschwindigkeit der erfindungsgemäßen Siliconzusammensetzungen. Diese Inhibitoren und Stabilisatoren sind auf dem Gebiet der additionsvernetzenden Zusammensetzungen sehr gut bekannt. Beispiele gebräuchlicher Inhibitoren sind acetylenische Alkohole, wie 1-Ethinyl-1-cyclohexanol, 2-Methyl-3-butin-2-ol und 3.5-Dimethyl-1-hexin-3-ol, 3-Methyl-1-dodecin-3-ol, Polymethylvinylcyclosiloxane wie 1,3,5,7-Tetravinyltetramethyltetracyclosiloxan, niedermolekulare Siliconöle mit Methylvinyl-SiO_{1/2}-Gruppen und/oder R₂vinylSiO_{1/2}-Endgruppen, wie Divinyltetramethydisiloxan, Tetravinyldimethyldisiloxan, Trialkylcyanurate, Alkylmaleate, wie Diallylmaleate, Dimethylmaleat und Diethylmaleat, Alkylfumarate, wie Diallylfumarat und Diethylfumarat, organische Hydroperoxide wie Cumolhydroperoxid, tert-Butylhydroperoxid und Pinanhydroperoxid, organische Peroxide, organische Sulfoxide, organische Amine, Diamine und Amide, Phosphane und Phosphite, Nitrile, Triazole, Diaziridine und Oxime. Die Wirkung dieser Inhibitorzusätze (E) hängt von ihrer chemischen Struktur ab, so dass die Konzentration individuell bestimmt werden muss. Inhibitoren und Inhibitormischungen werden vorzugsweise in einem Mengenanteil von 0,00001 % bis 5 % bezogen auf das Gesamtgewicht der Mischung zugesetzt, bevorzugt 0,00005 bis 2 % und besonders bevorzugt 0,0001 bis 1 %.

Nach vermischen aller Komponenten der Siliconzusammensetzung liegt die dynamische Viskosität bei einer Scherrate von 1 s⁻¹ zwischen 10 mPa·s und 1.000 Pa·s, bevorzugt zwischen 100 mPa·s und 100 Pa·s und besonders bevorzugt zwischen 200 mPa·s und 50 Pa·s, gemessen nach DIN EN ISO 3219: 1994 und DIN 53019 mittels eines kalibrierten Rheometers mit einem Kegel-Platte-System, Kegel CP50-2 mit einem Öffnungswinkel von 2° bei 25°C und einer Scherrate von 1 s⁻¹. Ein geeignetes Messgerät ist beispielsweise das Rheometer Gerät MCR302 erhältlich bei der Anton Paar GmbH, Österreich (105 µm Spaltmaß).

Die erfindungsgemäßen vernetzbaren Siliconzusammensetzungen haben den Vorteil, dass sie in einem einfachen Verfahren unter Verwendung leicht zugänglicher Ausgangsstoffe und damit wirtschaftlich hergestellt werden können. Die erfindungsgemäßen vernetzbaren Zusammensetzungen haben den weiteren Vorteil, dass sie als einkomponentige Formulierung bei 25°C und Umgebungsdruck eine gute Lagerstabilität aufweisen und erst bei erhöhter Temperatur rasch vernetzen. Die erfindungsgemäßen Siliconzusammensetzungen haben den Vorteil, dass diese bei zweikomponentiger Formulierung nach Vermischen der beiden Komponenten eine vernetzungsfähige Siliconmasse ergeben, deren Verarbeitbarkeit über einen langen Zeitraum hinweg bei 25°C und Umgebungsdruck bestehen bleibt, also extrem lange Topfzeit zeigen, und erst bei erhöhter Temperatur rasch vernetzt.

Beispiele für auf dem Markt erhältliche Siliconzusammensetzungen sind (je nach Viskosität der Materialien kann für eine bessere Verarbeitbarkeit Lösungsmittel zu gegeben werden):
Materialien der WACKER Chemie AG: ELASTOSIL® P-Reihe (7010, 7600, 7613, 7161-160, 7616-195, 7618, 7619, 7622, 7623, 7624, 7628, 7629, 7630, 7633, 7636, 7642-220, 7670, 671, 7676, 7682, 7683/15, 7683/25, 7683/47, 7683/50, 7683/55, 7684/60, 7685, 7686, 7687, 7688, 7700, 7710, 7720, 7731, 7742, 7770, 7707 US, 7915, etc.), ELASTOSIL® M-Reihe (4115, 4125, 4370, 4400, 4440, 4441, 4470, 4600, 4601, 4615, 4630, 4635, 4640, 4645, 4641, 4643, 4644, 4670, 4647, 4648, 4670), ELASTOSIL® RT-Reihe (601, 602, 604, 607, 615, 617, 619, 620, 622, 623, 624, 625, 626, 627, 628, 629, 630, 633, 646, 670, 672, 675, 678, 685, etc.), ELASTOSIL® SOLAR-Reihe (2000, 2200, 2202, 3210, etc.), ELASTOSIL® LR-Reihe (3003/03, 3003/05, 3003/10, 3003/20, 3070/20, 3844/20, 3846/20, 3856/20, 3003/30, 3004/30, 3005/30, 3040/30, 3044/30, 3065/30, 3070/30, 3071/30, 3072/30, 3843/30, 3844/30, 3846/30, 3856/30, 3003/40, 3003/50, 3003/60, 3003/70, 3003/80, 3003/85, 3004/40, 3004/50, 3004/60, 3004/70, 3005/40, 3005/50, 3005/60, 3040/40, 3040/50, 3040/60, 3043/40, 3043/50, 3043/60, 3043/70, 3015/70, 3023/60, 3092/65, 3094/60, 3065/50, 3066/40, 3066/60, 3066/80, 3070/40, 3070/50, 3070/60, 3071/40, 3071/50, 3071/60, 3072/40, 3074/60, 3076/70, 3170/40, 3841/50, 3842/40, 3842/50, 3842/60, 3842/70, 3162, etc.), ELASTOSIL® FLR-Reihe (3900/40, 3900/60, 3905/40, 3905/60, etc.), ELASTOSIL® R-Reihe, WACKER SILGEL®-Reihe (610, 611, 612, 613, 616, 619, etc.), SEMICOSIL®-Reihe, POWERSIL®-Reihe, LUMISIL®-Reihe, GENIOMER®-Reihe, SILPURAN®-Reihe, DEHESIVE®-Reihe.

Weiter sind zusätzlich zu den oben genannten vernetzbaren Siliconzusammensetzungen für den Auftrag von zusätzlichen Schichten nicht aushärtende Siliconzusammensetzungen wie beispielsweise Siliconöle verwendbar. Hierbei sind folgende Produkte der WACKER Chemie AG, Deutschland, einsetzbar: WACKER® AK SILICONOEL Reihe, POWERSIL® FLUID TR Reihe, SILFAR® Reihe. Generell sind siliconbasierte PSA (Pressure Sensitive Adhesive) einsetzbar.

Auch ist bei unterschiedlichen Anwendungen eine Verwendung von nicht aushärtenden Druckmassen als Stützmaterial oder Trennschicht von Vorteil. Diese Massen lassen sich nachträglich durch Spülen und/oder erwärmen rückstandfrei vom oder aus dem Druckkörper entfernen. Eine gängige Druckmasse ist hier Polyethylenglycol (PEG). Geeignete Stützmassen sind beispielsweise in WO 2017/020971 A1 und WO 2018/036640 A1 beschrieben.

Die in der vorliegenden Offenbarung genannten Siliconschichten, Siliconfolien bzw. die einzelnen Schichten von Silicon-Mehrschichtverbunden weisen vorzugsweise eine Dicke von 0,1 bis 400 µm, besonders bevorzugt von 1 bis 200 µm, ganz besonders bevorzugt von 1 bis 150 µm und insbesondere bevorzugt von 5 bis 100 µm und jeweils eine Dickengenauigkeit von ±5 % gemessen auf einer Fläche von 200 cm²; bevorzugt eine Dickengenauigkeit von jeweils ±3% auf.

Die Bestimmung der absoluten Schichtdicke kann mit Hilfe einer REM-Analyse (Rasterelektronenmikroskop-Analyse) erfolgen und wird mit einem Kryoschnitt durchgeführt. Die Oberflächengüte und Rauigkeit werden beispielsweise mit Hilfe eines Konfokal-Mikroskops ermittelt.

Bevorzugt wird wenigstens die, dem Druckmassenträger (33) bzw. der Siliconmasse (35) zugewandte Oberfläche des Anlagenträgers (36), auf ein Potential Phi_2 aufgeladen, wobei Phi_2 und Phi_1 entgegengesetzte Polaritäten aufweisen und Phi_2 und Phi_1 so gewählt werden, dass wenigstens ein Teil der Ladungsmenge der in Schritt (v) auf den Anlagenträger (36) transferierten Siliconzusammensetzung auf der Oberfläche des Anlagenträgers (36) neutralisiert wird.

Bevorzugt ist zwischen dem Druckmassenträger und der Siliconzusammensetzung eine opake Ablöseschicht angeordnet, die sich bei Bestrahlung mit Laserstrahlen erhitzt. Die opake Ablöseschicht kann dabei dauerhaft mit dem Druckmassenträger verbunden sein, oder als sich ablösende bzw. auflösende Schicht ausgestaltet sein.

Bevorzugt befindet sich der Fokuspunkt der Laserstrahlen oberhalb des Druckmassenträgers.

Bevorzugt weist die Siliconzusammensetzung eine dynamische Viskosität von 10 mPa·s oder mehr und 1.000 Pa·s oder weniger, besonders bevorzugt 1 bis 100 Pa·s, auf, gemessen nach DIN EN ISO 3219: 1994 und DIN 53019 mittels eines kalibrierten Rheometers mit einem Kegel-Platte-System, Kegel CP50-2 mit einem Öffnungswinkel von 2° bei 25°C und einer Scherrate von 1 s⁻¹.

Bevorzugt ist die Siliconzusammensetzung eine additionsvernetzende Siliconzusammensetzung und umfasst folgende Komponenten:
(A) eine organische Verbindung oder eine siliciumorganische Verbindung, enthaltend mindestens zwei Reste mit aliphatischen Kohlenstoff-Kohlenstoff-Mehrfachbindungen,
(B) eine Siliciumorganische Verbindung, enthaltend mindestens zwei Si-gebundenen Wasserstoffatome,
   oder anstelle von (A) und/oder (B) oder zusätzlich zu (A) und (B)
(C) eine Siliciumorganische Verbindung, enthaltend Si-C-gebundene Reste mit aliphatischen Kohlenstoff-Kohlenstoff-Mehrfachbindungen und Si-gebundene Wasserstoffatome, und
(D) ein Hydrosilylierungskatalysator.

Bevorzugt umfasst die additionsvernetzende Siliconzusammensetzung folgende weitere Komponente:
(E) ein oder mehrere Füllstoffe ausgewählt aus der Gruppe bestehend aus pyrogener oder gefällter Kieselsäure mit einer BET-Oberfläche von mindestens 50 m²/g, Ruß, Aktivkohle, Graphit, Graphene, Diamant, Kohlenstoffnanoröhren, Aluminiumnitrid, Aluminumoxid, Bariumtitanat, Berylliumoxid, Bornitrid, Magnesiumoxid, partikuläres Metall, Siliciumcarbid, Wolframcarbid, Zinkoxid, Titandioxid, Ferrite, NIR-Absorber, MIR-Absorber und Kombinationen dieser Füllstoffe.

Bevorzugt ist die Siliconschicht eine dielektrische Siliconschicht oder eine elektrisch leitende Siliconschicht.

Bevorzugt weist die Siliconschicht eine Schichtdicke von 0,1 µm bis 200 µm auf, gemessen mittels Rasterelektronenmikroskop-Analyse.

Bevorzugt ist der Druckmassenträger hoch durchlässig für die Laserstrahlen und wird ausgewählt aus der Gruppe bestehend aus Glas, Quarzglas, Polyethylenterephthalat (PET), Polycarbonat (PC), Polymethylmethacrylat (PMMA), und Zinkselenid-Glas.

Bevorzugt wird der Anlagenträger aus der Gruppe bestehend aus PET, Glas, ultradünnes biegsames Glas und Metall ausgewählt. Auf dem Anlagenträger können im Umlauf oder bereits aus vorherigen Prozessschritten, vernetzte Siliconschichten, Schichten aus vernetzbarer Siliconzusammensetzung, Silicon-Mehrschichtverbunde mit wenigstens zwei Schichten aus gehärtetem Silicon, und/oder metallische Schichten platziert sein.

Bevorzugt sind die vorherigen auf dem Anlagenträger befindlichen Schichten, eine Siliconfolie mit einer Foliendicke von 0,1 µm bis 200 µm oder ein Silicon-Mehrschichtverbund mit wenigstens zwei Schichten aus gehärtetem Silicon mit jeweils einer Schichtdicke von 0,1 µm bis 200 µm , jeweils gemessen mittels Rasterelektronenmikroskop-Analyse.

Bevorzugt wird auf die transferierte Siliconzusammensetzung eine Siliconfolie mit einer Foliendicke von 0,1 µm bis 200 µm oder ein Silicon-Mehrschichtverbund mit wenigstens zwei Schichten aus gehärtetem Silicon mit jeweils einer Schichtdicke von 0,1 µm bis 200 µm, jeweils gemessen mittels Rasterelektronenmikroskop-Analyse, laminiert.

Bevorzugt wird die Siliconfolie, die auflaminiert wird oder die auf dem Anlagenträger bereitgelegt wird, durch Ablösung von einem Folienträger erhalten, wobei die Ablösung folgende Schritte umfasst:
- Eintauchen des Folienträgers mit der sich darauf befindlichen Siliconfolie in ein Flüssigkeitsbad und/oder Besprühen der Innenseite des bereits von der Siliconfolie abgelöstem Folienträgers mit Flüssigkeit mittels einer Sprüheinheit in Richtung noch nicht abgelöster Siliconfolie; und
- Ablösen der Siliconfolie vom Folienträger.

Bevorzugt wird die abgelöste Siliconfolie mittels eines geregeltem Perforationstester auf Beschädigungen geprüft wird. Verwendete lonisierungsspannungen sind hierbei im Bereich von 100 bis 40.000 V, bevorzugt 2.000 bis 20.000 V.

Bevorzugt werden auf die transferierte Siliconzusammensetzung eine oder mehrere weitere Siliconschichten durch Wiederholung der Schritte (i) bis (vi) des oben genannten Lasertransferdruck-Verfahrens aufgebracht.

Bevorzugt ist der Anlagenträger als ein sich bewegendes Trägerband ausgestaltet, das aus einer Anlagenträgerrolle (2) zugeführt wird und nach Beschichtung in einer Speicherrolle (18a) gesammelt wird.

In einer alternativen Ausführungsform ist der Anlagenträger als ein sich bewegendes Umlaufband ausgestaltet und wird über einen Bandspeicher (18b) im Kreis gefahren, bis die Beschichtung mit ein oder mehreren Siliconschichten und ggf. Laminierung mit weiteren Folien abgeschlossen ist.

Bevorzugt ist die Laserquelle dazu eingerichtet, den Anlagenträger oder die darauf aufgebrachten Siliconschichten aufzurauen, abzutragen, zu strukturieren und/oder zu schneiden.

Das erfindungsgemäße Verfahren kann zur Herstellung von Kompositelektroden verwendet werden.

Bevorzugt ist die Siliconschicht eine elektrisch leitende Siliconschicht und das Verfahren umfasst folgende Schritte:
- Bereitstellen einer dielektrischen Schicht, vorzugsweise eine dielektrische Siliconschicht,
- Aufbringen einer elektrisch leitenden Metallschicht auf die dielektrischen Schicht;
- Aufbringen der elektrisch leitenden Siliconschicht auf die elektrisch leitende Metallschicht;
- Aufbringen einer weiteren elektrisch leitenden Metallschicht auf die elektrisch leitende Siliconschicht;
- Aufbringen einer weiteren dielektrischen Schicht, vorzugsweise eine dielektrische Siliconschicht, auf die weitere elektrisch leitende Metallschicht.

Bevorzugt weist die dielektrische Schichten jeweils eine Schichtdicke von 5 µm bis 100 µm auf, die elektrisch leitenden Metallschichten jeweils eine Schichtdicke von 0,01 µm bis 5 µm und die elektrisch leitenden Siliconschicht eine Schichtdicke von 5 µm bis 100 µm, gemessen mittels Rasterelektronenmikroskop-Analyse.

Bevorzugt wird der aus Schritt (v) resultierende Druckmassenträger mit nicht transferierter, vernetzbarer Siliconzusammensetzung wieder vollständig mit vernetzbarer Siliconzusammensetzung beschichtet und für die Aufbringung einer oder mehrerer weiterer Siliconschichten mittels Laser-Transferdruck verwendet.

Bevorzugt umfasst die vollständige Beschichtung folgende Schritte:
- Ablösen der nicht transferierten Siliconzusammensetzung vom Druckmassenträger mit Hilfe eines Abtragesystems (das umfasst auch das Ablösen der übrigen, nicht vernetzten und/oder vernetzten Siliconzusammensetzungen aus den Bereichen vormalig transferierter Siliconzusammensetzungen);
- Aufbereitung der abgelösten Siliconzusammensetzung in einem Aufbereitungssystem; und
- Auftragung der aufbereiteten Siliconzusammensetzung auf den Druckmassenträger mit Hilfe eines Auftragesystems.

Gängige Lasertransferdruck- Prozesse (LIFT = Laser Induced Forward Transfer) sind in der Literatur ausreichend beschrieben und Stand der Technik.

Bei der Anwendung mit Siliconzusammensetzungen hat sich die Erweiterung mit einer definierten Aufladung und der zusätzlichen Anwendung elektrostatischer Felder als vorteilhaft erwiesen (EF LIFT = Electric Field Laser Induced Forward Transfer).

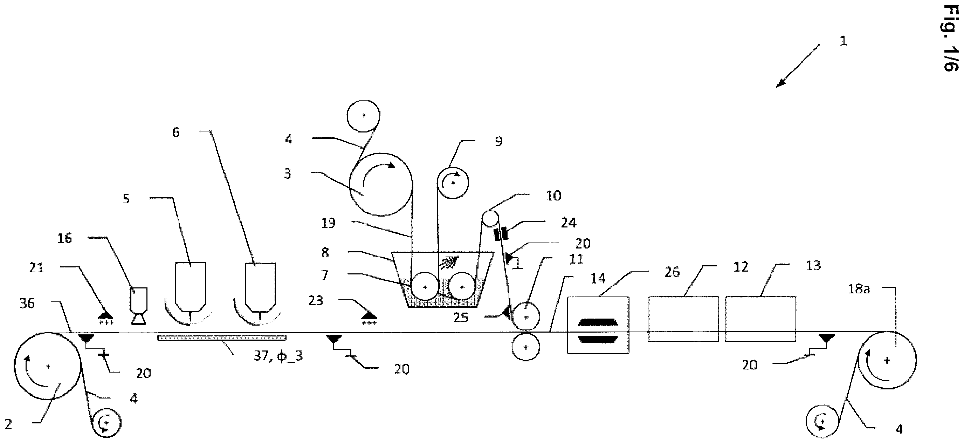

Im Folgenden werden mehrere Ausführungsformen der Erfindung beispielhaft anhand von Figuren 1 bis 6 beschrieben. Diese sind jedoch nicht als abschließend für die Ausgestaltungsformen der vorliegenden Erfindung zu verstehen.

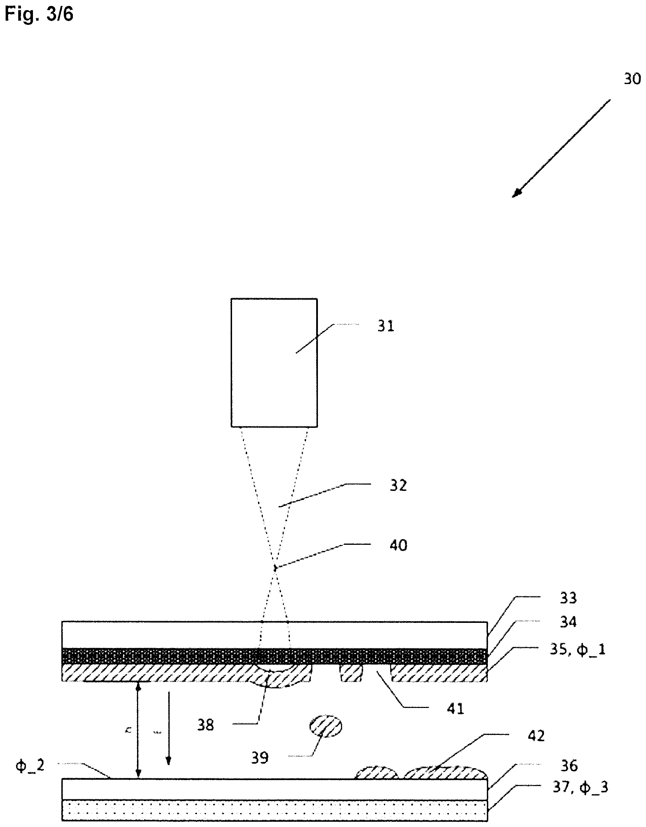

In Figur 3 ist ein solcher EF LIFT-Prozess mit der Skizze (30) abgebildet. Dabei wird mittels einer Laserquelle (31) eine Siliconzusammensetzung (35) über einen Laserstrahl (32) von einem für Laserstrahlung durchlässigen Druckmassenträger (33) abgelöst. Die Ablösung erfolgt im Ablösebereich (38). Hierbei wird durch den Laserstrahl (32) eine Erwärmung induziert, die eine Gasbildung (z.B. durch Verdampfung, Sublimation oder Zersetzung mindestens einer in der Siliconzusammensetzung (35) enthaltenen Komponente) verursacht. In einer weiteren Ausführungsform kann der Transfer von Laserstrahlung in Wärme durch eine zusätzliche opake Ablöseschicht (34) vorgenommen werden. Dies ist besonders vorteilhaft bei optisch transparenten Siliconelastomeren. Die Ablösung der Siliconzusammensetzung (35) reicht bei gängigen LIFT-Prozessen aus, um abgelöste Druckmassen (39) auf einen Anlagenträger (36) zu platzieren. Im besonderen Fall des LIFT-Prozesses mit Siliconelastomeren ist eine Verbesserung dieses Ablösens und Platzierens mit einer zusätzlichen Aufladung der Druckmasse und des Trägerbereiches zu erreichen. Dabei wird die Siliconzusammensetzung (35) mit dem elektrischen Potential (Phi_1), die Oberfläche des Anlagenträgers (36) mit dem elektrischen Potential (Phi_2) und die Elektrode (37) mit dem elektrischen Potential (Phi_3) aufgeladen. Die Polarität der Potentiale ist dabei so zu wählen, dass sich eine entgegengesetzte Ladung ergibt. Durch die Ladungen der Schichten im Abstand (h) voneinander entstehen elektrischen Felder (E). Diese bewirken wiederum auf die Siliconzusammensetzung (35) Kräfte in Richtung des Anlagenträgers (36). Somit wird eine abgelöste Druckmasse (39) durch die elektrostatischen Kräfte beschleunigt und in Richtung des Anlagenträgers (36) bewegt. Die abgelöste Siliconzusammensetzung (39) wird beim Ablösen und beim Auftreffen mechanisch erheblichen Scherkräften ausgesetzt. Eine vorteilhafte Materialzusammensetzung (z. B. scherverdünnende Silicone), wirkt hier vorteilhaft bei der Bildung einer geschlossenen Schicht (42).

Das scherverdünnende Verhalten von Siliconzusammensetzungen ist beispielsweise in WO 2017/081028 A1 in Zusammenhang mit ballistischen Druckverfahren beschrieben.

Weiter wirken die elektrostatischen Kräfte der verbleibenden Ladungen in der gesetzten Schicht (42) in Richtung der Elektrode (37). Vorteilhaft für die Relaxation erweist sich eine Aufladung des Anlagenträgers (36) an der Oberfläche mit dem Potential (Phi_2), in geringeren Höhen als die Ladungsmenge der gesetzten Siliconzusammensetzung (39). Eine verbleibende Ladung der Masse (42) ist so zu wählen, dass eine Beeinflussung der Felder (E) so gering wie möglich ist, jedoch eine Relaxation der Schicht (42) verbessert oder beschleunigt wird.

In vielen Ausführungen des bekannten LIFT Verfahrens wird auf die Fokussierung des Laserstrahls auf die Grenzfläche der Druckmasse und des Druckmassenträgers (33) verwiesen. In der Ausführung mit Siliconen hat die Fokussierung oberhalb des Druckmassenträgers ein besseres Druckbild zur Folge. Der Fokuspunkt (40) liegt dabei im Bereich einiger Mikrometer bis einiger Millimeter oberhalb des Druckmassenträgers (33). Eine Fokussierung des Laserstrahls auf, innerhalb oder unter der Grenzfläche ergibt zunächst eine Ablösung der Siliconzusammensetzung (39), jedoch führt dies anschließend zu einer erheblichen Nacherwärmung auf dem Anlagenträger (36) und damit zu einem Verbrennen oder thermischen Degenerieren der applizierten Siliconzusammensetzung (42).

Gängige Laserquellen (31) sind beispielsweise Nd:YAG-Laser (Neodym-dotierten Yttrium-Aluminium-Granat-Laser), welche Laserstrahlung im Bereich NIR (nahes Infrarot, ca. 0,78 bis 3 µm) abgeben. Diese Wellenlängen werden bei den meisten Lasersystemen zum Einkoppeln in opake Medien wie Metalle verwendet. Vorteilhaft ist in der erfindungsgemäß beschriebenen Anwendung, die Verwendung von Trägermaterial wie Glas, Quarzglas,Polyethylenterephthalat (PET), Polycarbonat (PC), Polymethylmethacrylat (PMMA) usw. für den Druckmassenträger (33). Bei transparenten Siliconen ist das Vorliegen einer opaken Beschichtung (34) oder absorbierender Zusätze in der Siliconzusammensetzung wie beispielsweise Ruß, Graphite, Graphene, Kohlenstoffnanoröhren (CNT) notwendig. Elektrisch nichtleitende Absorber sind beispielsweise bei der Firma FEW Chemicals GmbH, Deutschland, kommerziell erhältlich.

Eine weitere Ausführung des EF LIFT-Prozesses kann in der Form einer Änderung der Wellenlänge des Lasers (31) in dem Bereich MIR (mittleres Infrarot, ca. 3 bis 50 µm) erfolgen. Gängige Laserquellen sind hierbei in einem Wellenlängenbereich von 10,6 µm (CO2 Laser). In dieser speziellen Konfiguration können transparente Siliconelastomere ohne Zusätze von Absorbern und ohne eine opake Ablöseschicht (34) im EF LIFT-Prozess verwendet werden. Der Druckmassenträger (33) ist in dieser Konfiguration als optisch durchgängig für die entsprechenden Wellenlängen auszuführen. Vorzugsweise wird hierbei bei einer Wellenlänge von 10,6 µm, ZnSe-Glas (Zinkselenid) verwendet. Besonders werden hierbei anti-Reflexionsbeschichtungen an den Grenzflächen der ZnSe-Träger verwendet. Ein gängiger Zulieferer ist herbei die Firma LASER COMPONENTS GmbH, Deutschland.

Im erfindungsgemäßen Verfahren weist der Laser eine Wellenlänge im Bereich von 0,78 µm bis 20 µm, besonders bevorzugt im Bereich 0,9 µm bis 12 µm, ganz besonders bevorzugst im Bereich 0,9 µm bis 1,1 µm auf.

Ablöseschichten (34) sind dem Fachmann bekannt und können beispielsweise aus CVD (chemische Gasphasenabscheidung) oder PVD (physikalische Gasphasenabscheidung) abgeschiedenen Schichten oder anderen opaken Stoffen bestehen. Vorzugweise kann diese Schicht so an den Druckmassenträger (33) gebunden sein, dass sich bei einer Erwärmung durch den Laser (31) keine Ablösung der Ablöseschicht (34) vom Druckmassenträger (33) einstellt.

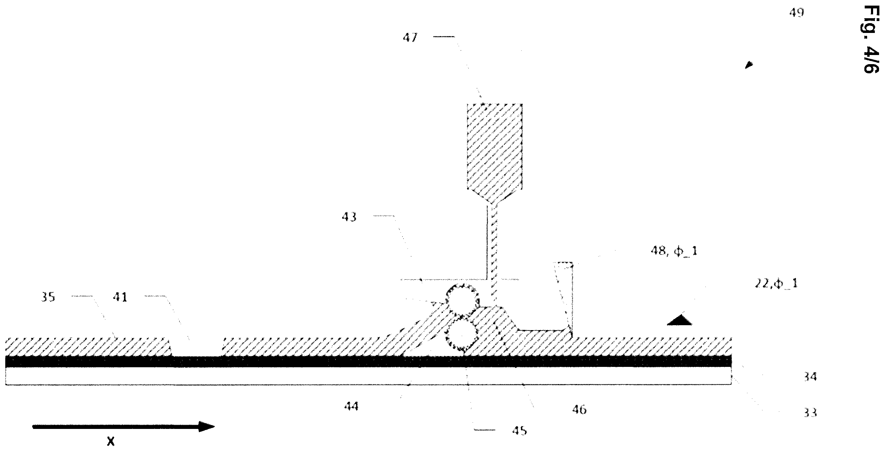

In Figur 4 ist in der Prozessskizze (49) das Auftragssystem für die Druckmassen (35) abgebildet. Hierbei wird die nicht transferierte Druckmasse (35) durch ein Abtrags- und Auftragssystem (43) vom Druckmassenträger (33) und/oder von der Ablöseschicht (34) abgelöst und diese wieder vollflächig mit Druckmasse beschichtet. Durch die Abtragseinheit (44) wird die nichttransferierte Druckmasse (35) und teilweise nicht abgelöste Druckmasse in den Bereichen (41) vom Druckmassenträger (33,34) abgezogen. Der Druckmassenträger bewegt sich dabei in positiver X-Richtung auf die Ablöseeinheit zu. Vorteilhaft haben sich PTFE-Abstreifer und Abziehkanten aus einem weichen Material als Abtragseinheit (44) erwiesen. Die abgelöste alte Druckmasse wird durch eine Aufbereitungseinheit (45) von der Abtragseinheit (44) abtransportiert, durchmischt und einer definierten mechanischen Scherung ausgesetzt. Auftretende Scherraten sind vorzugsweise im Bereich 0,1-1000 s⁻¹, insbesondere im Bereich 0,1-100 s⁻¹ zu wählen. Zu hohe Scherraten können die Einmischung und die Eigenschaften der Füllstoffe der Druckmasse negativ beeinflussen. Zu geringe Scherraten führen zu einer schlechten Durchmischung und /oder einer schlechten Auftragung der Neuschicht. Eine Zuführung und Auffrischung des Druckmaterials wird durch eine Zuführung von Druckmasse aus einem Vorratsbehälter (47) in den Überdruckbereich (46) des Auftragssystems erreicht. Die Zuführung kann dabei als Stichleitung aus dem Behälter (47) zum Bereich (46) oder als Ringleitung mit dauerhaftem Materialfluss zwischen beiden ausgeführt sein. Vorzugsweise wird die Druckmasse im Behälter (47) und im Bereich (46) durch eine Zirkulation der Druckmassen zwischen beiden Bereichen dauerhaft mit einer Scherung beansprucht. Insbesondere wird zusätzlich zur Scherung eine Heizung des Behälters (47) oder des gesamten Auftragssystems vorgenommen. Hierbei wird abgetragene Druckmasse durch die Materialzirkulation zwischen (47) und (46) wieder erwärmt. Die auftretenden Materialtemperauren liegen im Bereich von -10°C bis 150°C besonders bevorzugt im Bereich 20°C bis 100°C, insbesondere bevorzugt im Bereich 50°C bis 80°C.

Materialzuführungen zum Vorratsbehälter (47) werden durch gängige Dosiersysteme mit Entgasung vorgenommen. Solche Systeme sind beispielswiese von der Firma ViscoTec Pumpen- u. Dosiertechnik GmbH, Deutschland, erhältlich.

Durch die Druckerhöhung und Scherung im Bereich (46) wird eine homogene und luftblasenfreie Siliconschicht in der Dicke 1 bis 400 µm, vorzugsweise 10 bis 50 µm, insbesondere 10 bis 20 µm auf den Druckmassenträger aufgetragen. Mit dem Präzisionsdickenabzug (48) wird die erneuerte Druckmassenschicht (35) nochmalig auf eine Schichtdickenabweichung +/- 5 % präzisiert und kann ggf. mit einem elektrischen Potential (Phi_1) beaufschlagt werden. Hierbei ist der Präzisionsdickenabzug elektrisch leitend ausgeführt. Vorzugsweise werden hier, mindestens ein gelapptes Präzisionsrakel aus Hartmetall verwendet. Besonders bevorzugt werden hier Rakel bzw. Materialien verwendet, welche keinen Materialabtrag und korrosions- sowie lösemittelbeständig sowie in medizinischen Anwendungen zugelassen sind.

In einer weiteren Form kann die Aufladung der Druckmasse auf das Potential (Phi_1) durch eine Ionisierung (22) berührungslos erfolgen. Dies kann einzeln oder in Kombination mit der Aufladung am Dickenabzug (48) erfolgen. Gängige geregelte Ionisierungssysteme sind dem Fachmann bekannt und beispielsweise bei der Firma Simco-Ion, Niederlande, erhältlich.

Figur 1 veranschaulicht einen Rolle-zu-Rolle-Prozess zur Herstellung von Siliconelastomer-Mehrschichtsystemen mit verschiedenen Ausführungsformen.

In der Prozessskizze (1) speisen die Rollen (2) und (3), bestehend aus einem nicht dehnbaren Trägerband (36), einem sich gegebenenfalls darauf befindenden ultradünnen elektroaktiven Elastomerfilm (55) oder Elastomerlaminat (14) und optional einer Kaschierfolie (4) den Prozess (1). Die Kaschierfolie (4) wird während des Abwickelvorganges entfernt.

Die Beschichtungssysteme (5) und (6) bringen, nach dem Prinzip (30), Druckmassen (Elektrodenmaterial und/oder elektrisch nicht-leitendes Material) unvernetzt auf den Anlagenträger (36) oder ein Laminat (14) auf. Die geometrische Form der aufzubringenden Schichten kann je nach Anforderungen variabel ausgeführt sein. Zu Sicherstellung der geometrisch definierten Positionierung dieser Schichten, kann ein aktives Kamerasystem (16) eingesetzt werden. Hierbei verifiziert das Kamerasystem (16) die Form sowie die Position der bereits aufgebrachten Schichten im Laminat (14). Eine übergeordnete Steuer- und Regeleinheit steuert und positioniert entsprechend der Informationen aus dem Kamerasystem (16) sowie weiteren Regelgrößen wie beispielsweise Bahngeschwindigkeit, oder eingestellten elektrischen Potentialen wie beispielsweise Phi_1,Phi_2 und Phi_3 die Beschichtungssysteme (5) und (6).

Die aufgebrachten Schichten werden anschließend mit einem, in der Delaminationseinheit (7) vom Folienträger (19) abgelösten Elastomerfilm (55) laminiert.

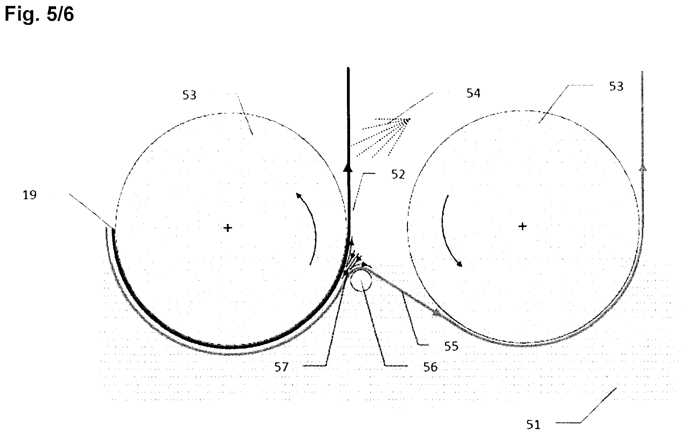

Die Figur 5 zeigt in der Detailansicht (50) einen schonenden und defektfreien Ablösemechanismus für ultradünne Elastomerfolie (vorzugsweise 1 bis 200 µm). Der ultradünne Elastomerfilm (55) wird von dem nicht dehnbaren Folienträgerband (19), vorzugsweise in einem Flüssigkeitsbad (51) eingetaucht oder unter Einfluss der Flüssigkeitsbenetzung (52), insbesondere erzeugt durch eine Sprüheinheit (54), kontinuierlich abgelöst. Das freie Folienträgerband (19) wird anschließend auf einer Wickeleinheit (9) gesammelt.

Das Prinzip der schonenden Ablösung des Elastomerfilms beruht auf der Verminderung der chemischen und physikalischen Haftung durch die Anwesenheit einer flüssigen hydrophilen Zwischenschicht (57) im Bereich der Ablösung des hydrophoben Elastomerfilm und Folienträger. Beim Ablösen bildet die Flüssigkeitsgrenzfläche im Bad eine Kontaktlinie auf dem Folienträger, die eine kapillarinduzierte Abziehkraft am Rand der Elastomerfilm (55) ausübt. Die Vorrichtung kann optional eine, in der Position verstellbare, Führungswalze (56) enthalten, welche einen Ablösewinkel zwischen Elastomerfilm und Folienträger definiert.

Erfolgt eine Vorbehandlung des Folienträgers (19) mit beispielsweise einem im Bad (8) in der Flüssigkeit (51) löslichen Trennmittelkomponenten, so kann hier die erforderliche Ablösekraft zwischen dem vollvernetzten Elastomerfilm und Folientträger durch das Auflösen dieser Schicht im Flüssigkeitsbecken gezielt verringert werden. Der erfindungsgemäße Ablösemechanismus hat zusätzlich den Vorteil, dass sich unter Anwesenheit einer Flüssigkeitsschicht eine Neutralisation der elektrostatischen Ladungen stattfindet sowie anhaftende Schmutzpartikel kontinuierlich entfernt werden. Die am Elastomerfilm (55) anhaftende Flüssigkeitstropfen werden anschließend durch die Luftstrahleinheit (10), beispielsweise Luftwalzen, Luftdüsen oder Ventilatoren vom Elastomerfilm (55) entfernt.

Die Drehgeschwindigkeiten der Walzen (53) können optional unterschiedlich sein, um damit eine definierte Vorstreckung des freien Elastomerfilms (55) zu erzeugen.

Bei der flüssigkeitsunterstützten Ablösung des Elastomerfilms, insbesondere durchgeführt mit Reinstwasser, kann durch eine Zugabe von oberflächenaktiven Additiven (z.B. Tenside) unterstützt werden. Generelle Oberflächenmodifizierungen des Folienträgers (19) können hierbei Haftkräfte minimieren und somit den Ablöseprozess verbessern. Gängige Verfahren und Wege sind im Stand der Technik bekannt.

Durch die Entladeeinrichtung (20) wird der Anlagenträger (36) nach abrollen von der Anlagenträgerrolle (2) sowie alle darauf befindlichen Siliconmassen, Siliconschichten bzw. Laminate (14) entladen.

Durch eine berührungslose Aufladung (21), wird die Anlagenträgeroberfläche (zu bedruckende Oberflache des Anlagenträgers (36)) auf das Potential (Phi_2) aufgeladen. Die Anlagenträgeroberfläche ist hierbei die oberste Fläche auf die mit den Drucksystemen (5) und (6) gedruckt werden soll.

In den Drucksystemen wird die Druckmasse auf Potential (Phi_1) geladen. Unterhalb der Drucksysteme (5) und (6) direkt anschließend an den Anlagenträger (36) befindet sich die Feldelektrode (37) auf Potential (Phi_3).

Durch die Entladeeinrichtung (20) wird der Anlagenträger (36) sowie alle darauf befindlichen Siliconmassen, Siliconschichten bzw. Laminate (14) entladen. Durch die Aufladeeinheit (23) wird die oberste Schicht und/oder applizierte Druckmasse (42) auf dem Anlagenträger (36) definiert auf das Potential (A) geladen.

Durch die Aufladeeinrichtung (25) wird die freie Elastomerfolie (55) auf der der applizierten Druckmasse (42) zugewandten Seite örtlich auf das Potential (B) geladen. Die Potentiale (A) und (B) haben unterschiedliche Polarität und bewirken eine Anziehung und Haftung bei Ablage des Siliconfilms (55) auf den Druckmassen (42).

Der Prozess der elektrostatischen Lamination ist im Stand der Technik bekannt und wird bei unterschiedlichsten Laminationvorgängen verwendet.

Durch die Rolle (11) werden der Ablagewinkel und ein evtl. notwendiger mechanischer Druck für die Ablage und auf das Laminat (14) eingestellt. Das so erzeugte Laminat (14) wird durch eine Feldeinheit (26) geführt in der magnetische und/oder elektrische Felder die nicht ausgehärtete Siliconschichten beeinflussen. Dies kann von einer induktiven Aufheizung bis zu einer Ausrichtung magnetischer Füllstoffe beliebig variable Effekte in den Elastomerschichten erzeugen.

In der Aushärtestation (12) wird das Laminat vernetzt. In der Kühlstation (13) wird das Laminat abgekühlt. Das ausgehärtete und abgekühlte Laminat wird dann unter Einlage einer Kaschierfolie (4) auf der Rolle (18a) gesammelt (aufgerollt).

Zur Fehlererkennung wird mittels eines Perforationstesters (24) berührungslos die freischwebende Elastomerfolie (55) auf Beschädigungen und Schwachstellen geprüft. Nach der Prüfung erfolgt eine Entladung durch eine Entladeeinrichtung (20). Schwach- oder Fehlstellen werden durch einen elektrischen Durchschlag erkannt und vom Perforationstester (24) gemeldet. Der auftretende Lichtbogen an den Fehlstellen verursacht einen Abbrand und eine erkennbare Färbung bzw. Veränderung an den Durchschlagstellen. Erkannte und gemeldete Fehlstellen werden in einer übergeordneten Steuer- und Regeleinheit ausgewertet und entsprechend der Bahnposition zugeordnet und ggf. markiert. Bereiche unterhalb und umgebend der Fehlstelle werden in der Software der Steuer- und Regeleinheit vermerkt und später als Ausschuss deklariert.

In einer gesonderten Form wird die Fehlstelle in ihrer Position vermerkt und bei einem späteren neuen Druck bzw. Laminationsverfahren durch einen Laser flächig abgetragen und durch die Druckeinheit (6) wieder mit isolierendem Siliconelastomer aufgefüllt.

Kritische Punkte wie Ablösung und Ablösewinkel, Vorspannung, Dehnung, Ablagewinkel und Lufteinschlüsse sind hierbei von erheblicher Einflussstärke auf die Präzision und die Funktion der späteren EAP-Systeme. Beispielsweise ergibt ein nicht optimales Ablegen der Folie sowie mögliche Lufteinschlüsse beim Aufbringen einer zusätzlichen Schicht eine spätere Blasenbildung beim Aushärteprozess.

Einfaches mechanisches Ablösen beschädigt oder teilschädigt den Siliconfilm. Dies führt bei späterem Einsatz in EAP-Systemen zu elektrischen Durchschlägen und Bauteilversagen.

Durch jegliche trockene Ablösung der Folie vom Folienträger bilden sich Spikes und die Folie wird partiell überdehnt und bekommt Risse oder Löcher. Diese partiellen Überbeanspruchungen treten bei allen Abziehverfahren an Luft auf. Alleinig mit einer Ablösung unter Verwendung eines Wasserfilmes wird die Haftkraft und somit die mechanische Belastung der Siliconfolie soweit vermindert, dass eine Beschädigung vermieden werden kann. Ein Abziehen unter Wasser oder allein ein Benetzen der Ziehkannte haben eine erhebliche Reduktion der Haftkraft und eine Verminderung der mechanischen Belastung der Folie zur Folge.

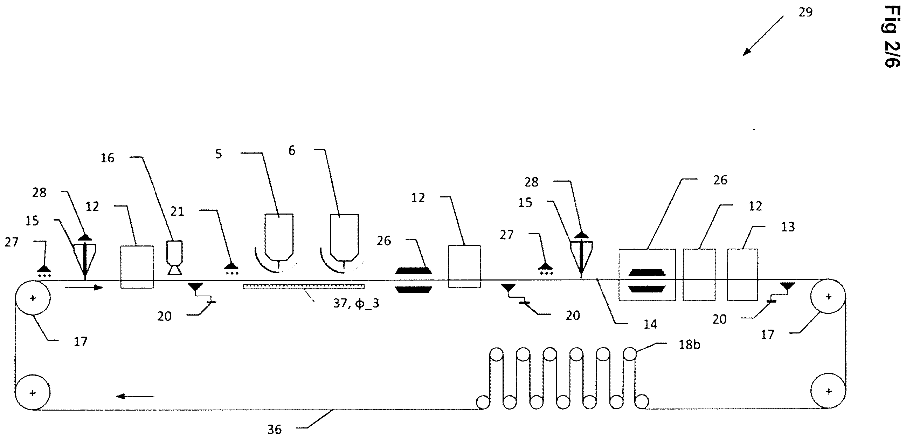

In Figur 2 ist eine besondere Ausführungsform des Prozesses mit der Prozessskizze (29) angegeben. Hierbei wird keine ausgehärtete Siliconschicht appliziert bzw. laminiert, sondern durch Auftragssysteme werden diese im Nassverfahren aufgebracht. Der Prozess zeichnet sich dadurch aus, dass die oben genannte Anlagenträger (36) als nicht dehnbares Umlaufband ausgeführt ist. Auf diesem Umlaufband können sich bereits mehrere Schichten aus Siliconelastomeren befinden. Die elektrisch neutrale Schicht auf dem Umlaufband wird dabei aus dem Schlaufenspeicher (18b) herausgeführt und durch die Aufladeeinheit (27) auf das Potential (C) geladen. Durch das Auftragswerk (15) wird eine Siliconschicht vollflächig auf dem Anlagenträger und den sich darauf befindenden Schichten abgelegt. Die Aufladeeinheit (28) lädt dabei die Siliconmasse des Auftragswerkes (15) auf das Potential (D). Die Potentiale (C) und (D) haben unterschiedliche Polarität und bewirken somit elektrostatische Kräfte. Der Auftragsprozess wird dabei durch die Einwirkung der elektrostatischen Kräfte unterstützt. Nach der Ablage bzw. dem Auftragen einer Schicht durch das Auftragswerk (15) wird durch eine Aushärtestation (12) eine teilweise bis vollständige Aushärtung der applizierten Schicht vorgenommen. Durch die Entladestation (20) wird der Anlagenträger mit allen darauf befindlichen Schichten elektrisch neutralisiert.

Der Druckprozess (5,6) wird wieder wie oben beschrieben, bis zur Aushärtestation (12) vorgenommen. Danach kann optional nochmalig ein Auftrag einer Siliconschicht, wie zuvor beschrieben, erfolgen. Die Gesamtaushärtung und Beeinflussung durch Felder erfolgt anschließend in der Feldeinheit (26), Aushärtestation (12) sowie die Abkühlung in der Abkühlstation (13).

Über die Bahnführungen (17) wird das Umlaufband bzw. der Anlagenträger (36) bezüglich der Bahnposition und Bahnspannung geregelt. Im Schlaufenspeicher (18b) wird die notwendige Prozessmenge bzw. Chargenmenge entsprechend der gewünschten Chargengröße zwischengespeichert. Ist die Anzahl der gewünschten Schichten erreicht, so wird das Siliconelastomerlaminat vom Umlaufband abgenommen. Gängige Abnahmevorrichtungen sind im Stand der Technik bekannt.

In einer speziellen Ausgestaltung des Prozesses, wird vor dem EF LIFT-Prozess die zu beschichtende Oberfläche aufgeraut und/oder abgetragen respektive strukturiert. Weiter kann das Lasersystem dazu eingerichtet sein, eine Vereinzelung auf dem Anlagenträgerband (36) vorzunehmen. Dabei wird das Anlagenträgerband(36) nicht beschädigt.

Ein Gravurlaser mit einer Wellenlänge 10,6 µm kann beispielsweise zum Schneiden und gezielten Abtrag von Siliconschichten verwendet werden. Weiter ist eine Verbesserung der Schneidgenauigkeit beispielsweise mit einem 9,3 µm Laser erreichbar. Der Einbau von verschiedenen Laserquellen (z.B. Wellenlänge: 1,06 µm und 10,6 µm) ist somit dazu geeignet das System zum Schneiden als auch zum LIFT Druck zu verwenden.

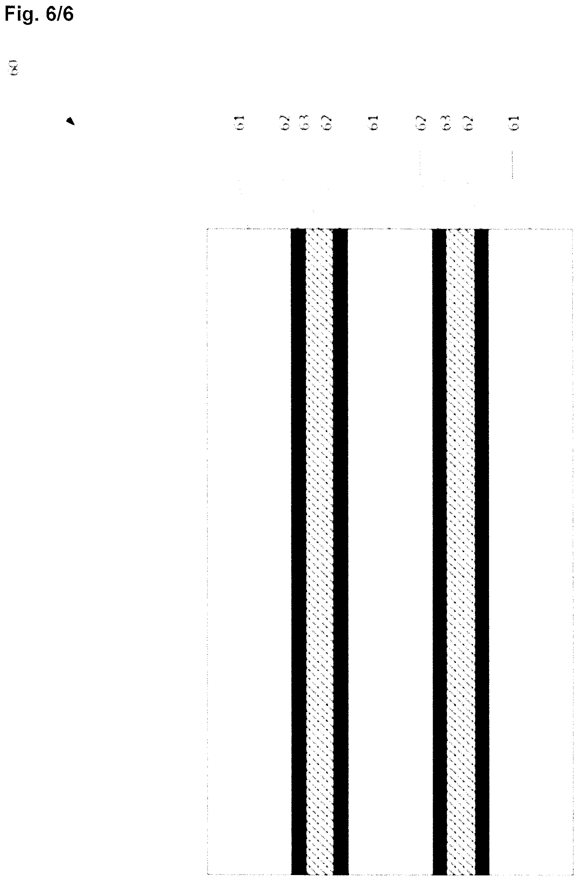

In einer speziellen Ausführung des Prozesses wird eine Elektrode als Mehrschichtsystem aufgebaut (Kompositelektrode). In Figur 6 ist eine solche Elektrodenanordnung mit der Schnittskizze (60) zu sehen. Eine dünne Siliconschicht (62) umfassend sehr gut leitende Stoffe wie Metallen, CNT, Leitruß, etc., wird mit einer sehr flexiblen leitenden Schicht (63) zu einer Elektrode verbunden. Dabei übernimmt die Schicht (63) den Ladungstransport zur Elektroden Ladungsfläche (62). Hoch leitfähige Schichten (62) weisen meist keine dauerhafte Elastizität auf und werden im Laufe der plastischen Beanspruchung der EAP-Systeme brüchig und neigen dazu, den Ladungstransport zu verschlechtern bis zur gänzlichen Isolation einzelner Bereiche. Eine Trennung der Funktionen Ladungsfläche sowie Ladungstransport löst dieses Problem.

Prozesstechnisch ist die Aufbringung der metallischen Schichten im LIFT- sowie im EF LIFT- und weiterer unterschiedlicher Verfahren durchführbar.

Die Applikation im dem obigen beschriebenen Verfahren kann durch Druckbänder mit Metalldruckmassen bzw. Druckschichten vorgenommen werden. Ein direktes Aufbringen auf eine nicht ausgehärtete Siliconelastomermasse erübrigt eine Binderkomponente.

Beispielsweise kann die Elektrodenfläche aus Elastomer mit einem Rußfüllstoff gebildet werden. Dabei ist zu beachten, dass der Füllstoffanteil meist über 50 Gew.-% basierend auf der gesamten Elektrodenmasse sein muss, um eine ausreichende Leitfähigkeit zu erhalten. Bei mechanischer Belastung (Zugdehnung) kann eine Verschlechterung der Leitfähigkeit beobachten werden.

Alle EAP-Systeme haben den physikalischen Hintergrund von Ladungen, die sich anziehen und/oder abstoßen. Die Aufbauten sind immer in Schichten aufgebaut und somit sind die Ladungen in Ladungsflächen oder Bereiche einzuordnen. Diese Bereiche bestimmen den effektiven Abstand der Elektroden, der in die Effektivität eingeht. Die mit leitfähigem Material, vorzugsweise CNT, gefüllte Siliconschicht wird zum Ladungstransport an die Elektrodenfläche genutzt. Die Elektrodenfläche wird durch eine sehr dünne Metallschicht vorzugsweise Aluminium, erzeugt.

Fehlt die elastische Leitungsschicht in einem Aktor erfolgt eine erhöhte Erwärmung an mechanisch belasteten Bereichen sowie Hotspots an der degenerierten Elektrodenfläche. Dies, ist auf eine schlechte Verbindung der Schicht, die Rissbildung sowie fehlende Elastizität zurückzuführen. Eine Verbindung mit einer elastischen Leitungsschicht löst dieses Problem.

Vorzugsweise wird das erfindungsgemäße Verfahren zur Herstellung von Sensoren, Aktoren oder anderen EAP-Systemen umfassend wenigstens zwei Elektroden und wenigstens eine zwischen den Elektroden angeordnete, dielektrische Siliconschicht eingesetzt.

Die Siliconschicht kann dabei eine Elektrodenschicht sein und/oder die dielektrische Schicht in Sensoren, Aktoren oder anderen EAP-Systemen.

### Beispiele

Der EF LIFT Prozess wurde mit einem gängigen Laser-Gravursystem der Firma TROTEC Laser Deutschland GmbH durchgeführt. Zu Anwendung kommt dabei ein System der Baureihe Speedy 100flexx 60/20 mit Dual Laserquelle (60 W 10,6 um CO2 Laser; 20 W 1,06 µm Faser-Laser). Als Träger und Druckmassenträger werden gängige Quarzglasplatten (300x300x3 mm) der Firma GVB GmbH Solution in Glas, Deutschland, verwendet. Zur Aufbringung des Druckmassenfilmes wird ein ZAA2300 Automatisches Filmziehgerät mit einem ZUA 2000 Universal-Applikator der Firma Zehntner GmbH, Schweiz, verwendet. Als Druckmasse wird ein RTV-2 Silicon mit 0,5 m% CNT und 5 m% Leitruß (Carbon Black) mit dem Vernetzer PT15 der Firma WACKER Chemie AG, Deutschland, verwendet.

Mit dem Rakelsystem wird einseitig auf einer Quarzglasscheibe eine homogene Schicht in einer Dicke von 60 µm und in den Abmessungen 200x 200mm mittig aufgerakelt. Die Randbereiche der Scheibe bleiben dabei frei von Druckmasse. In den Schneidraum des Lasers wird eine unbeschichtete und gereinigte Scheibe als zu bedruckende Fläche eingelegt. Die beschichtete Scheibe wird mit der Beschichtungsseite der unbeschichteten Scheibe zugewandt, in einem Abstand von 200 µm auf der ersten Scheibe platziert. Der Abstand wird dabei durch Abstandshalter wie beispielsweise 100 µm Mikroskopplatten eingestellt. Als Druckvorlage in der Steuersoftware des Lasersystems, ist eine flächig gefüllte Geometrie ohne Graubereiche und Schattierungen zu wählen. Weiter ist die Laserleistung im Schneidmodus Faserlaser zwischen 40-60 % bei einem 20 W Laser ausreichend. Der Laserspeed ist zwischen 50 und 70 % zu wählen. Der Fokuspunkt sollte ca. 4 bis 4,5 mm oberhalb der Grenzfläche Beschichtung bzw. der Quarzglasplatte liegen. Die gewählten Geometrien konnten so durch den Laser transferiert werden.

In einer weiteren Ausführung wird auf der unbeschichteten Glasscheibe eine Siliconfolie (ELASTOSIL®-Film mit 100 µm Dicke, erhältlich bei der WACKER Chemie AG) durch einen Wasserfilm fixiert. Die Oberseite der Siliconfolie wird anschließend durch einen Ladesystem der Firma Simco-Ion, bestehend aus Hochspannungsladegerät der Serie CM LITE, HDR Ladeelektrode, auf -300V geladen. Die Messung der Aufladung wird mittels des Elektrostatik Messgerätes SK050, und der Auswerteinheit SK1000 der Firma Keyence nachgeprüft. Eine vergleichbare Aufladung auf +100 V wird mit der Druckmassenschicht durchgeführt. Anschließend werden beide Platten wieder im Schneidraum des Lasers platziert. Der Abstand der Druckmasse zur Siliconfolie kann im Bereich 100 bis 400 µm mit Abstandshalter gewählt werden. Der LIFT Vorgang ist vergleichbar der oberen Beschreibung durchzuführen. Ohne die genannte Aufladung werden abgelöste Druckmassen nicht vollständige bzw. ungezielt transferiert. Weiter wird durch die Aufladung eine homogenere Ablage und ein besserer Verbund der transferierten schichten erreicht.

### Bezugszeichen der Figuren

- 1: Prozessskizze Prozess 1
- 2: Anlagenträgerrolle
- 3: Folienträgerrolle
- 4: Kaschierfolie
- 5: Beschichtungssystem für Elektrodenmaterial
- 6: Beschichtungssystem für elektr. isolierendes Material
- 7: Film-Delaminationseinheit (Elastomer - Träger)
- 8: Flüssigkeitsbecken/Benetzung
- 9: Aufwicklereinheit für Trägerfolie
- 10: Luftstrahleinheit (entfernen Tropfen/Flüssigkeit von Elastomerfilm)
- 11: Laminationswalzen
- 12: Aushärtestation
- 13: Kühlstation
- 14: Laminat (mind. Träger; Elastomer; Elektrode; Elastomer)
- 15: Auftragswerk
- 16: Aktives Kamerasystem
- 17: Bahnführung Umlaufband
- 18a: Speicherrolle
- 18b: Bandspeicher
- 19: Folienträger
- 20: Elektrostatische Entladung
- 21: Aufladung Potential φ_2
- 22: Aufladung Potential φ_1
- 23: Aufladung Potential A
- 24: Perforationstest
- 25: Aufladung Potential B
- 26: Feldeinheit (elektrische Felder, magnetische Felder)
- 27: Aufladung Potential C
- 28: Aufladung Beschichtung Potential D
- 29: Prozessskizze Prozess 2
- 30: Skizze EF LIFT
- 31: Laserquelle
- 32: Laserstrahl
- 33: Druckmassenträger
- 34: Ablöseschicht
- 35: Siliconzusammensetzung/ Elektrodenmasse / Druckmasse / Stützmasse
- 36: Anlagenträger mit oder ohne Siliconelastomerfilm oder Laminat
- 37: Feldelektrode EF LIFT
- 38: Ablösebereich
- 39: abgelöste Druckmasse / Elektrodenmasse
- 40: Fokuspunkt Laserstrahl
- 41: Leerbereich Träger / Bereich der abgelösten Druckmasse
- 42: Applizierte Druckmasse / Auftragswerk Druckschicht
- 43: Abtrags- und Auftragssystem
- 44: Abtragssystem nicht transferierte Druckmasse
- 45: Aufbereitung und Scherung der Druckmassen
- 46: Überdruckbereich Auftrag Druckmasse
- 47: Vorratsbehälter
- 48: Präzisionsdickenabzug und Ladungskannte
- 49: Prozessskizze Auftragswerk Druckschicht
- 50: Detailskizze Ablösemechanismus Flüssigkeitsablösung
- 51: Flüssigkeit
- 52: Flüssigkeitsfilm
- 53: Rotationswalzen
- 54: Flüssigkeitssprüheinheit
- 55: Elastomerfilm
- 56: Führungswalze
- 57: induzierte Kraft (Peeling) - Flüssigkeitsminiskus
- 60: Schnittskizze Kompositelektrode
- 61: EAP Schicht (nichtleitendes Siliconelastomer)
- 62: Elektroden-Ladungsfläche
- 63: Leitungsschicht

## Patentansprüche

1. Verfahren zur Aufbringung wenigstens einer Siliconschicht mittels Laser-Transferdruck, wobei das Verfahren folgende Schritte umfasst:
(i) Bereitstellen einer Laserquelle (31);
(ii) Bereitstellen eines Druckmassenträgers (33) unterhalb der Laserquelle (31), wobei der Druckmassenträger (33) transparent für Laserstrahlung ist und auf der unteren Seite mit einer vernetzbaren Siliconzusammensetzung (35) beschichtet ist und wenigstens die Oberfläche der vernetzbaren Siliconzusammensetzung auf ein Potential Phi_1 aufgeladen wird;
(iii) Bereitstellen eines Anlagenträgers (36) unterhalb des Druckmassenträgers (33);
(iv) Bereitstellen einer Elektrode (37) unterhalb des Anlagenträgers (36), wobei die Elektrode (37) auf ein Potential Phi_3 aufgeladen wird, wobei Phi_1 und Phi_3 entgegengesetzte Polaritäten aufweisen;
(v) Bestrahlung des Druckmassenträgers (33) mit Laserstrahlen (32), so dass wenigstens ein Teil der vernetzbaren Siliconzusammensetzung (35) abgelöst wird und auf den Anlagenträger (36) transferiert wird; und
(vi) Ausbildung einer Siliconschicht durch vollständige oder teilweise Vernetzung der auf den Anlagenträger (36) transferierten Siliconzusammensetzung (35).

2. Verfahren gemäß Anspruch 1, wobei wenigstens die der vernetzbaren Siliconzusammensetzung (35) zugewandte Oberfläche des Anlagenträgers (36) auf ein Potential Phi_2 aufgeladen wird, wobei Phi_2 und Phi_1 entgegengesetzte Polaritäten aufweisen und Phi_2 so gewählt wird, dass wenigstens ein Teil der Ladungsmenge der in Schritt (v) auf den Anlagenträger (36) transferierten Siliconzusammensetzung (35) auf der Oberfläche des Anlagenträgers (36) neutralisiert wird.

3. Verfahren gemäß einem der Ansprüche 1 bis 2, wobei zwischen dem Druckmassenträger (33) und der Siliconzusammensetzung (35) eine opake Ablöseschicht (34) angeordnet ist, die sich bei Bestrahlung mit Laserstrahlen (32) erhitzt.

4. Verfahren gemäß einem der Ansprüche 1 bis 3, wobei sich der Fokuspunkt (40) der Laserstrahlen (32) oberhalb des Druckmassenträgers (33) befindet.

5. Verfahren gemäß einem der Ansprüche 1 bis 4, wobei die Siliconzusammensetzung eine dynamische Viskosität von 10 mPa·s oder mehr und 1.000 Pa·s oder weniger aufweist, gemessen nach DIN EN ISO 3219: 1994 und DIN 53019 mittels eines kalibrierten Rheometers mit einem Kegel-Platte-System, Kegel CP50-2 mit einem Öffnungswinkel von 2° bei 25°C und einer Scherrate von 1 s⁻¹.

6. Verfahren gemäß einem der Ansprüche 1 bis 5, wobei die Siliconzusammensetzung eine additionsvernetzende Siliconzusammensetzung ist und folgende Komponenten umfasst:
(A) eine organische Verbindung oder eine siliciumorganische Verbindung, enthaltend mindestens zwei Reste mit aliphatischen Kohlenstoff-Kohlenstoff-Mehrfachbindungen,
(B) eine siliciumorganische Verbindung, enthaltend mindestens zwei Si-gebundenen Wasserstoffatome,
oder anstelle von (A) und/oder (B) oder zusätzlich zu (A) und (B)
(C) eine siliciumorganische Verbindung, enthaltend Si-C-gebundene Reste mit aliphatischen Kohlenstoff-Kohlenstoff-Mehrfachbindungen und Si-gebundene Wasserstoffatome, und
(D) ein Hydrosilylierungskatalysator.

7. Verfahren gemäß Anspruch 6, wobei die additionsvernetzende Siliconzusammensetzung folgende weitere Komponente umfasst:
(E) ein oder mehrere Füllstoffe ausgewählt aus der Gruppe bestehend aus pyrogener oder gefällter Kieselsäure mit einer BET-Oberfläche von mindestens 50 m²/g, Ruß, Aktivkohle, Graphit, Graphene, Diamant, Kohlenstoffnanoröhren, Aluminiumnitrid, Aluminumoxid, Bariumtitanat, Berylliumoxid, Bornitrid, Magnesiumoxid, partikuläres Metall, Siliciumcarbid, Wolframcarbid, Zinkoxid, Titandioxid, Ferrite, NIR-Absorber, MIR-Absorber und Kombinationen dieser Füllstoffe.

8. Verfahren gemäß einem der Ansprüche 1 bis 7, wobei die Siliconschicht eine dielektrische Siliconschicht oder eine elektrisch leitende Siliconschicht ist.

9. Verfahren gemäß einem der Ansprüche 1 bis 8, wobei die Siliconschicht eine Schichtdicke von 0,1 µm bis 200 µm aufweist, gemessen mittels Rasterelektronenmikroskop-Analyse.

10. Verfahren gemäß einem der Ansprüche 1 bis 9, wobei der Druckmassenträger (33) aus der Gruppe bestehend aus Glas, Quarzglas, PET, Polycarbonat, PMMA und Zinkselenid-Glas ausgewählt ist.

11. Verfahren gemäß einem der Ansprüche 1 bis 10, wobei der Anlagenträger (36) aus der Gruppe bestehend aus PET-Folie, Metallfolie und Glas ausgewählt wird.

12. Verfahren gemäß einem der Ansprüche 1 bis 11, wobei auf dem Anlagenträger (36) zusätzlich folgendes aufgebracht ist: ein oder mehrere vernetzte Siliconschichten, eine oder mehrere Schichten vernetzbarer Siliconzusammensetzung, Silicon-Mehrschichtverbunde mit wenigstens zwei Schichten aus gehärtetem Silicon sowie metallische Schichten.

13. Verfahren gemäß Anspruch 12, wobei die Dicke der einzelnen Schichten 0,1 µm oder mehr bis 200 µm oder weniger beträgt, jeweils gemessen mittels Rasterelektronenmikroskop-Analyse.

14. Verfahren gemäß einem der Ansprüche 1 bis 13, wobei auf die transferierte Siliconzusammensetzung eine Siliconfolie mit einer Foliendicke von 0,1 µm bis 200 µm oder ein Silicon-Mehrschichtverbund mit wenigstens zwei Schichten aus gehärtetem Silicon mit jeweils einer Schichtdicke von 0,1 µm bis 200 µm, jeweils gemessen mittels Rasterelektronenmikroskop-Analyse, laminiert werden.

15. Verfahren gemäß Anspruch 14, wobei die Siliconfolie (55) durch Ablösung von einem Folienträger (19) erhalten wird, wobei die Ablösung folgende Schritte umfasst:
- Eintauchen der auf Trägerfolie (19) aufgebrachten Siliconfolie (55) in ein Flüssigkeitsbad (51) und/oder Besprühen der Innenseite bereits von der Siliconfolie abgelöster Trägerfolie (19) mit Flüssigkeit mittels einer Sprüheinheit (54) in Richtung noch nicht abgelöster Siliconfolie; und
- Ablösen der Siliconfolie von der Kaschierfolie.

16. Verfahren gemäß Anspruch 15, wobei die abgelöste Siliconfolie (55) mittels geregelter Perforationstester (24) auf Schwachstellen geprüft wird.

17. Verfahren gemäß einem der Ansprüche 1 bis 16, wobei auf die transferierte Siliconzusammensetzung eine oder mehrere weitere Siliconschichten durch Wiederholung der Schritte (i) bis (vi) aufgebracht werden.

18. Verfahren gemäß einem der Ansprüche 1 bis 17, wobei der Anlagenträger (36) als ein sich bewegendes Trägerband ausgestaltet ist, das aus einer Anlagenträgerrolle (2) zugeführt wird und nach Beschichtung in einer Speicherrolle (3) gesammelt wird.

19. Verfahren gemäß einem der Ansprüche 1 bis 18, wobei der Anlagenträger (36) als ein sich bewegendes Umlaufband ausgestaltet ist und über einen Bandspeicher (18b) im Kreis gefahren wird, bis die Beschichtung mit ein oder mehreren Siliconschichten abgeschlossen ist.

20. Verfahren gemäß einem der Ansprüche 1 bis 19, wobei die Laserquelle (31) dazu eingerichtet ist die Oberfläche des Anlagenträgers (36) oder der darauf aufgebrachten Siliconschicht aufzurauen, abzutragen, zu strukturieren und/oder zu schneiden.

21. Verfahren gemäß einem der Ansprüche 1 bis 20, wobei die Siliconschicht eine elektrisch leitende Siliconschicht ist und das Verfahren folgende Schritte umfasst:
- Bereitstellen einer dielektrischen Schicht (61);
- Aufbringen einer elektrisch leitenden Metallschicht (62) auf die dielektrische Schicht (61);
- Aufbringen der elektrisch leitenden Siliconschicht (63) auf die elektrisch leitende Metallschicht (62);
- Aufbringen einer weiteren elektrisch leitenden Metallschicht (62) auf die elektrisch leitende Siliconschicht (63);
- Aufbringen einer weiteren dielektrischen Schicht (61) auf die weitere elektrisch leitende Metallschicht (62).

22. Verfahren gemäß Anspruch 21, wobei die dielektrischen Schichten (61) jeweils eine Schichtdicke von 5 µm bis 200 µm aufweisen, die elektrisch leitenden Metallschichten (62) jeweils eine Schichtdicke von 10 nm bis 100 µm aufweisen und die elektrisch leitenden Siliconschicht (63) eine Schichtdicke von 5 µm bis 200 µm aufweist, jeweils gemessen mittels Rasterelektronenmikroskop-Analyse .

23. Verfahren gemäß einem der Ansprüche 1 bis 22, wobei der aus Schritt (v) resultierende Druckmassenträger (33) mit nicht transferierter, vernetzbarer Siliconzusammensetzung (35) wieder vollständig mit vernetzbarer Siliconzusammensetzung (35) beschichtet wird und für die Aufbringung einer oder mehrerer weiterer Siliconschichten mittels Laser-Transferdruck verwendet wird.

24. Verfahren gemäß Anspruch 23, wobei die vollständige Beschichtung folgende Schritte umfasst:
- Ablösen der nicht transferierten Siliconzusammensetzung (35) vom Druckmassenträger (33) mit Hilfe eines Abtragesystems (44);
- Aufbereitung der abgelösten Siliconzusammensetzung (35) in einem Aufbereitungssystem (45); und
- Auftragung der aufbereiteten Siliconzusammensetzung (35) auf den Druckmassenträger (33) mit Hilfe eines Auftragesystems (43).

25. Verfahren gemäß einem der Ansprüche 1 bis 24, wobei es sich um ein Verfahren zur Herstellung von Sensoren, Aktoren oder EAP-Schichtsystemen handelt.

26. Verfahren gemäß Anspruch 25, wobei die Siliconschicht als Elektrodenschicht und/oder als dielektrische Schicht in den Sensoren, Aktoren oder EAP-Schichtsystemen dient.

## Claims

1. Method for applying at least one silicone layer by laser transfer printing, the method comprising the following steps:
(i) providing a laser source (31);
(ii) providing a printing-compound carrier (33) beneath the laser source (31), the printing-compound carrier (33) being transparent to laser radiation and being coated on the lower side with a crosslinkable silicone composition (35), and at least the surface of the crosslinkable silicone composition being charged to a potential phi_1;
(iii) providing a deposition carrier (36) beneath the printing-compound carrier (33);
(iv) providing an electrode (37) beneath the deposition carrier (36), the electrode (37) being charged to a potential phi_3, where phi_1 and phi_3 have opposite polarities;
(v) irradiating the printing-compound carrier (33) with laser beams (32), so that at least a part of the crosslinkable silicone composition (35) is detached and is transferred to the deposition carrier (36); and
(vi) forming a silicone layer by completely or partly crosslinking the silicone composition (35) transferred to the deposition carrier (36).

2. Method according to Claim 1, wherein at least the surface of the deposition carrier (36) that is facing the crosslinkable silicone composition (35) is charged to a potential phi_2, where phi_2 and phi_1 have opposite polarities and phi_2 is chosen such that at least a part of the charge quantity of the silicone composition (35) transferred in step (v) to the deposition carrier (36) is neutralized on the surface of the deposition carrier (36) .

3. Method according to either of Claims 1 and 2, wherein disposed between the printing-compound carrier (33) and the silicone composition (35) there is an opaque detachment layer (34) which heats up on irradiation with laser beams (32).

4. Method according to any of Claims 1 to 3, wherein the focal point (40) of the laser beams (32) is located above the printing-compound carrier (33).

5. Method according to any of Claims 1 to 4, wherein the silicone composition has a dynamic viscosity of 10 mPa·s or more and 1000 Pa·s or less, measured according to DIN EN ISO 3219: 1994 and DIN 53019 by a calibrated rheometer having a cone-plate system, cone CP50-2 with an opening angle of 2°, at 25°C and a shear rate of 1 s⁻¹.

6. Method according to any of Claims 1 to 5, wherein the silicone composition is an addition-crosslinking silicone composition and comprises the following components:
(A) an organic compound or an organosilicon compound, containing at least two radicals having aliphatic carbon-carbon multiple bonds,
(B) an organosilicon compound containing at least two Si-bonded hydrogen atoms,
or instead of (A) and/or (B) or in addition to (A) and (B)
(C) an organosilicon compound containing SiC-bonded radicals having aliphatic carbon-carbon multiple bonds, and Si-bonded hydrogen atoms, and
(D) a hydrosilylation catalyst.

7. Method according to Claim 6, wherein the addition-crosslinking silicone composition comprises the following further component:
(E) one or more fillers selected from the group consisting of fumed or precipitated silica having a BET surface area of at least 50 m²/g, carbon black, activated carbon, graphite, graphenes, diamond, carbon nanotubes, aluminium nitride, aluminium oxide, barium titanate, beryllium oxide, boron nitride, magnesium oxide, particulate metal, silicon carbide, tungsten carbide, zinc oxide, titanium dioxide, ferrites, NIR absorbers, MIR absorbers, and combinations of these fillers.

8. Method according to any of Claims 1 to 7, wherein the silicone layer is a dielectric silicone layer or an electrically conducting silicone layer.

9. Method according to any of Claims 1 to 8, wherein the silicone layer has a layer thickness of 0.1 µm to 200 µm, measured by scanning electron microscope analysis.

10. Method according to any of Claims 1 to 9, wherein the printing-compound carrier (33) is selected from the group consisting of glass, vitreous silica, PET, polycarbonate, PMMA, and zinc selenide glass.

11. Method according to any of Claims 1 to 10, wherein the deposition carrier (36) is selected from the group consisting of PET film, metal foil, and glass.

12. Method according to any of Claims 1 to 11, wherein the deposition carrier (36) additionally bears the following: one or more crosslinked silicone layers, one or more layers of crosslinkable silicone composition, silicone multilayer composites having at least two layers of cured silicone, and metallic layers.

13. Method according to Claim 12, wherein the thickness of the individual layers is 0.1 µm or more to 200 µm or less, measured in each case by scanning electron microscope analysis.

14. Method according to any of Claims 1 to 13, wherein the transferred silicone composition is laminated with a silicone film having a film thickness of 0.1 µm to 200 µm or with a silicone multilayer composite having at least two layers of cured silicone each with a layer thickness of 0.1 µm to 200 µm, in each case measured by scanning electron microscope analysis.

15. Method according to Claim 14, wherein the silicone film (55) is obtained by detachment from a film carrier (19), the detachment comprising the following steps:
- immersing the silicone film (55) applied on carrier film (19) into a liquid bath (51) and/or spraying the inside of carrier film (19) already detached from the silicone film with liquid by means of a spraying unit (54) in the direction of silicone film not yet detached; and
- detaching the silicone film from the laminating film.

16. Method according to Claim 15, wherein the detached silicone film (55) is tested for weak points by regulated perforation testers (24).

17. Method according to any of Claims 1 to 16, wherein one or more further silicone layers are applied to the transferred silicone composition by repetition of steps (i) to (vi).

18. Method according to any of Claims 1 to 17, wherein the deposition carrier (36) is configured as a moving carrier belt which is supplied from a deposition carrier roll (2) and after coating is collected in a storage roll (3) .

19. Method according to any of Claims 1 to 18, wherein the deposition carrier (36) is configured as a moving circulating belt and is circulated via a belt store (18b) until the coating with one or more silicone layers is concluded.

20. Method according to any of Claims 1 to 19, wherein the laser source (31) is set up to roughen, ablate, structure and/or cut the surface of the deposition carrier (36) or of the silicone layer applied thereon.

21. Method according to any of Claims 1 to 20, wherein the silicone layer is an electrically conducting silicone layer and the method comprises the following steps:
- providing a dielectric layer (61);
- applying an electrically conducting metal layer (62) to the dielectric layer (61);
- applying the electrically conducting silicone layer (63) to the electrically conducting metal layer (62);
- applying a further electrically conducting metal layer (62) to the electrically conducting silicone layer (63);
- applying a further dielectric layer (61) to the further electrically conducting metal layer (62).

22. Method according to Claim 21, wherein the dielectric layers (61) each have a layer thickness of 5 µm to 200 µm, the electrically conducting metal layers (62) each have a layer thickness of 10 nm to 100 µm, and the electrically conducting silicone layer (63) has a layer thickness of 5 µm to 200 µm, measured in each case by scanning electron microscope analysis.

23. Method according to any of Claims 1 to 22, wherein the printing-compound carrier (33) resulting from step (v) with non-transferred, crosslinkable silicone composition (35) is coated again completely with crosslinkable silicone composition (35) and used for the application of one or more further silicone layers by laser transfer printing.

24. Method according to Claim 23, wherein the complete coating comprises the following steps:
- detaching the non-transferred silicone composition (35) from the printing-compound carrier (33) by means of a carry-off system (44);
- processing the detached silicone composition (35) in a processing system (45); and
- carrying the processed silicone composition (35) onto the printing-compound carrier (33) by means of a carry-on system (43).

25. Method according to any of Claims 1 to 24, wherein the method is a method for producing sensors, actuators or EAP layer systems.

26. Method according to Claim 25, wherein the silicone layer serves as an electrode layer and/or as a dielectric layer in the sensors, actuators or EAP layer systems.

## Revendications

1. Procédé pour l'application d'au moins une couche de silicone par impression par transfert au laser, le procédé comprenant les étapes suivantes :
(i) mise à disposition d'une source de laser (31) ;
(ii) mise à disposition d'un support de masse d'impression (33) sous la source de laser (31), le support de masse d'impression (33) étant transparent au rayonnement laser et revêtu sur la face inférieure d'une composition de silicone réticulable (35) et au moins la surface de la composition de silicone réticulable étant chargée à un potentiel Phi_1 ;
(iii) mise à disposition d'un support annexe (36) sous le support de masse d'impression (33) ;
(iv) mise à disposition d'une électrode (37) sous le support annexe (36), l'électrode (37) étant chargée à un potentiel Phi_3, Phi_1 et Phi_3 présentant des polarités opposées ;
(v) irradiation du support de masse d'impression (33) par des rayons laser (32) de telle sorte qu'au moins une partie de la composition de silicone réticulable (35) est détachée et transférée sur le support annexe (36) ; et
(vi) formation d'une couche de silicone par réticulation complète ou partielle de la composition de silicone (35) transférée sur le support annexe (36).

2. Procédé selon la revendication 1, au moins la surface orientée vers la composition de silicone réticulable (35) du support annexe (36) étant chargée à un potentiel Phi_2, Phi_2 et Phi_1 présentant des polarités opposées et Phi_2 étant choisi de manière telle qu'au moins une partie de la quantité de charges de la composition de silicone (35) transférée sur le support annexe (36) dans l'étape (v) est neutralisée sur la surface du support annexe (36).

3. Procédé selon l'une quelconque des revendications 1 à 2, une couche antiadhésive opaque (34) étant disposée entre le support de masse d'impression (33) et la composition de silicone (35), laquelle couche s'échauffe lors de l'irradiation par des rayons laser (32) .

4. Procédé selon l'une quelconque des revendications 1 à 3, le point focal (40) des rayons laser (32) se trouvant au-dessus du support de masse d'impression (33).

5. Procédé selon l'une quelconque des revendications 1 à 4, la composition de silicone présentant une viscosité dynamique de 10 mPa.s ou plus et de 1000 Pa.s ou moins, mesurée selon les normes DIN EN ISO 3219 : 1994 et DIN 53019 au moyen d'un rhéomètre étalonné pourvu d'un système cône-plaque, cône CP50-2 présentant un angle d'ouverture de 2° à 25°C et à une vitesse de cisaillement de 1 s⁻¹.

6. Procédé selon l'une quelconque des revendications 1 à 5, la composition de silicone étant une composition de silicone réticulant par addition et comprenant les composants suivants :
(A) un composé organique ou un composé organosilicié, contenant au moins deux radicaux présentant des liaisons carbone-carbone aliphatiques multiples,
(B) un composé organosilicié, contenant au moins deux atomes d'hydrogène liés par Si ou, au lieu de (A) et/ou de (B) ou en plus de (A) et de (B)
(C) un composé organosilicié, contenant des radicaux liés par SiC, présentant des liaisons carbone-carbone aliphatiques multiples et des atomes d'hydrogène liés par Si et
(D) un catalyseur d'hydrosilylation.

7. Procédé selon la revendication 6, la composition de silicone réticulant par addition comprenant les autres composants suivants :
(E) une ou plusieurs charges choisies dans le groupe constitué par la silice pyrogène ou précipitée présentant une surface BET d'au moins 50 m²/g, la suie, le charbon actif, le graphite, le graphène, le diamant, les nanotubes de carbone, le nitrure d'aluminium, l'oxyde d'aluminium, le titanate de baryum, l'oxyde de béryllium, le nitrure de bore, l'oxyde de magnésium, un métal particulaire, le carbure de silicium, le carbure de tungstène, l'oxyde de zinc, le dioxyde de titane, une ferrite, un absorbant des IR proches, un absorbant des IR moyens et les combinaisons de ces charges.

8. Procédé selon l'une quelconque des revendications 1 à 7, la couche de silicone étant une couche de silicone diélectrique ou une couche de silicone électroconductrice.

9. Procédé selon l'une quelconque des revendications 1 à 8, la couche de silicone présentant une épaisseur de couche de 0,1 µm à 200 µm, mesurée par analyse par microscopie électronique à balayage.

10. Procédé selon l'une quelconque des revendications 1 à 9, le support de masse d'impression (33) étant choisi dans le groupe constitué par le verre, le verre à quartz, le PET, le polycarbonate, le PMMA et le verre de séléniure de zinc.

11. Procédé selon l'une quelconque des revendications 1 à 10, le support annexe (36) étant choisi dans le groupe constitué par une feuille de PET, une feuille métallique et le verre.

12. Procédé selon l'une quelconque des revendications 1 à 11, les éléments suivants étant appliqués en plus sur le support annexe (36) ; une ou plusieurs couches réticulées de silicone, une ou plusieurs couches de compositions réticulables de silicone, des composites multicouches à base de silicone présentant au moins deux couches de silicone durci ainsi que des couches métalliques.

13. Procédé selon la revendication 12, l'épaisseur des différentes couches étant de 0,1 µm ou plus à 200 µm ou moins, mesurée à chaque fois par analyse par microscopie électronique à balayage.

14. Procédé selon l'une quelconque des revendications 1 à 13, une feuille de silicone présentant une épaisseur de feuille de 0,1 µm à 200 µm ou un composite multicouche à base de silicone présentant au moins deux couches de silicone durci, présentant à chaque fois une épaisseur de couche de 0,1 µm à 200 µm, mesurée à chaque fois par analyse par microscopie électronique à balayage, étant stratifié(e) sur la couche transférée de silicone.

15. Procédé selon la revendication 14, la feuille de silicone (55) étant obtenue par détachement d'un support de feuille (19), le détachement comprenant les étapes suivantes :
- immersion de la feuille de silicone (55) appliquée sur la feuille support (19) dans un bain de liquide (51) et/ou aspersion de la face interne de la feuille support (19) déjà détachée de la feuille de silicone par un liquide au moyen d'une unité de pulvérisation (54) dans le sens vers la feuille de silicone non encore détachée ; et
- détachement de la feuille de silicone de la feuille de contrecollage.

16. Procédé selon la revendication 15, la feuille de silicone (55) détachée étant testée au moyen d'un testeur de perforation (24) réglementé sur la présence de faiblesses.

17. Procédé selon l'une quelconque des revendications 1 à 16, une ou plusieurs autres couches de silicone étant appliquées, par répétition des étapes (i) à (vi), sur la composition de silicone transférée.

18. Procédé selon l'une quelconque des revendications 1 à 17, le support annexe (36) étant conçu comme une bande support en mouvement qui est alimentée à partir d'un rouleau (2) de support annexe et qui est recueillie après le revêtement dans un rouleau d'accumulation (3).

19. Procédé selon l'une quelconque des revendications 1 à 18, le support annexe (36) étant conçu comme une bande en circulation en mouvement et qui est guidé en circulation via un accumulateur de bande (18b) jusqu'à ce que le revêtement par une ou plusieurs couches de silicone soit terminé.

20. Procédé selon l'une quelconque des revendications 1 à 19, la source de laser (31) étant conçue pour rendre rugueux, pour éliminer, pour structurer et/ou pour couper la surface du support annexe (36) ou de la couche de silicone qui y est appliquée.

21. Procédé selon l'une quelconque des revendications 1 à 20, la couche de silicone étant une couche de silicone électroconductrice et le procédé comprenant les étapes suivantes :
- mise à disposition d'une couche diélectrique (61) ;
- application d'une couche métallique électroconductrice (62) sur la couche diélectrique (61) ;
- application de la couche de silicone électroconductrice (63) sur la couche métallique électroconductrice (62) ;
- application d'une autre couche métallique électroconductrice (62) sur la couche de silicone électroconductrice (63) ;
- application d'une autre couche diélectrique (61) sur l'autre couche métallique électroconductrice (62).

22. Procédé selon la revendication 21, les couches diélectriques (61) présentant à chaque fois une épaisseur de couche de 5 µm à 200 µm, les couches métalliques électroconductrices (62) présentant à chaque fois une épaisseur de couche de 10 nm à 100 µm et la couche de silicone électroconductrice (63) présentant une épaisseur de couche de 5 µm à 200 µm, mesurée à chaque fois par analyse par microscopie électronique à balayage.

23. Procédé selon l'une quelconque des revendications 1 à 22, le support de masse d'impression (33) résultant de l'étape (v) présentant la composition de silicone réticulable (35) non transférée étant de nouveau revêtu complètement par la composition de silicone réticulable (35) et utilisé pour l'application d'une ou de plusieurs autres couches de silicone par impression par transfert au laser.

24. Procédé selon la revendication 23, le revêtement complet comprenant les étapes suivantes :
- détachement de la composition de silicone (35) non transférée du support de masse d'impression (33) à l'aide d'un système d'élimination (44) ;
- traitement de la composition de silicone (35) détachée dans un système de traitement (45) ; et
- application de la composition de silicone (35) traitée sur le support de masse d'impression (33) à l'aide d'un système d'application (43).

25. Procédé selon l'une quelconque des revendications 1 à 24, le procédé étant un procédé pour la fabrication de capteurs, d'actionneurs ou de systèmes à couches EAP.

26. Procédé selon la revendication 25, la couche de silicone servant de couche d'électrode et/ou de couche diélectrique dans les capteurs, les actionneurs ou les systèmes à couches EAP.
